# EUROPÄISCHE PATENTSCHRIFT

(11) **EP 1 197 580 B1**
(45) Veröffentlichungstag und Bekanntmachung des Hinweises auf die Patenterteilung: **17.03.2004**
(21) Anmeldenummer: 01121453.3
(22) Anmeldetag: 07.09.2001
(51) Int. Cl.: C23C 14/54, C23C 14/34, C23C 14/56

(54) **Sputterbeschichtungsanlage zur Beschichtung von zumindest einem Substrat und Verfahren zur Regelung dieser Anlage**
Sputtering apparatus for coating at least one substrate and process for the regulation of the apparatus
Appareil de pulvérisation cathodique pour le revêtement d'au moins un substrat et procédé de regulation de l'appareil

(30) Priorität: 11.10.2000 DE 10050355; 23.07.2001 DE 10135761
(43) Veröffentlichungstag der Anmeldung: 17.04.2002
(73) Patentinhaber: INTERPANE Entwicklungs- und Beratungsgesellschaft mbH & Co. KG, D-37697 Lauenförde (DE)
(72) Erfinder: Bechtloff, Jürgen, Prof. Dr.-Ing., 59872 Meschede (DE); Hennes, Peter, 53757 St. Augustin-Angela (DE); Czybik, Manfred, 37697 Lauenförde (DE); Böwer, Reimund, 37688 Beverungen (DE)
(74) Vertreter: Körfer, Thomas, Dipl.-Phys.

(56) Entgegenhaltungen:
- DE-A- 4 429 013
- DE-C- 4 219 692
- DATABASE INSPEC [Online] INSTITUTE OF ELECTRICAL ENGINEERS, STEVENAGE, GB; FU C Y ET AL: "Neural manufacturing: A novel concept for processing modeling, monitoring, and control" Database accession no. 5276063 XP002187448 & PROCESS, EQUIPMENT, AND MATERIALS CONTROL IN INTEGRATED CIRCUIT MANUFACTURING, AUSTIN, TX, USA, 25-26 OCT. 1995, Bd. 2637, Seiten 31-39, Proceedings of the SPIE - The International Society for Optical Engineering, 1995, SPIE-Int. Soc. Opt. Eng, USA ISSN: 0277-786X
- DATABASE INSPEC [Online] INSTITUTE OF ELECTRICAL ENGINEERS, STEVENAGE, GB; JUNGHUI CHEN ET AL: "Optimal design using neural network and information analysis in plasma etching" Database accession no. 6163048 XP002187449 & JOURNAL OF VACUUM SCIENCE & TECHNOLOGY B (MICROELECTRONICS AND NANOMETER STRUCTURES), JAN.-FEB. 1999, AIP FOR AMERICAN VACUUM SOC, USA, Bd. 17, Nr. 1, Seiten 145-153, ISSN: 0734-211X
- DATABASE INSPEC [Online] INSTITUTE OF ELECTRICAL ENGINEERS, STEVENAGE, GB; MOYNE J R ET AL: "Adaptive extensions to a multibranch run-to-run controller for plasma etching" Database accession no. 5018025 XP002187450 & 41ST NATIONAL SYMPOSIUM OF THE AMERICAN VACUUM SOCIETY, DENVER, CO, USA, 24-29 OCT. 1994, Bd. 13, Nr. 3, pt.2, Seiten 1787-1791, XP000536503 Journal of Vacuum Science & Technology A (Vacuum, Surfaces, and Films), May-June 1995, USA ISSN: 0734-2101

## Beschreibung

Die Erfindung betrifft eine Sputterbeschichtungsanlage zur Beschichtung von zumindest einem Substrat, insbesondere einer Glasscheibe, und ein Verfahren zur Regelung dieser Sputterbeschichtungsanlage. Insbesondere dient die Regelung zum Einfahren der Kathode, d.h. zum Einstellen der Kathodenleistung auf einen vorgegebenen Betriebswert.

Eine Sputterbeschichtungsanlage gemäß dem Oberbegriff des Anspruchs 1 und ein Verfahren zur Regelung einer Sputterbeschichtungsanlage gemäß dem Oberbegriff des Anspruchs 14 sind aus der DE 43 03 462 C2 bekannt. Bei der bekannten Sputterbeschichtungsanlage wird die Kathodenleistung von einer Gleichstrom- oder einer Hochfrequenz-Leistungsversorgung bereitgestellt. Die Stabilisierung einer solchen Hochfrequenz-Leistungsversorgung ist aus der EP 0 902 457 A1 bekannt. Dabei wird mittels einer Fuzzy-Regelung eine Impedanz- und Amplitudenanpassung der Leistungsversorgung an das erzeugte Plasma erreicht.

Die bekannte Regelung hat jedoch mehrere Nachteile. Wird die Zufuhr des Reaktivgases in den Raum zwischen der Kathode und dem Substrat erhöht, dann verringert sich zugleich die Kathodenspannung mithin die Kathodenleistung. Die Regelung verändert den Reaktivgasfluß und damit indirekt die Kathodenspannung. Falls die Anzahl der Entladungen der Kathode über das Plasma stark ansteigt, wird Sauerstoff herausgenommen, so daß die Kathodenspannung ansteigt. Dadurch kommt es zu Verzögerungen. In der Praxis wird diese Kathodeneinfahrsteuerung von speziell geschulten Anlagenfahrern übernommen, die die Kathodenleistung und den Gasfluß des Reaktivgases manuell regeln, wobei sie die Anzahl der Entladungen der Kathode über das Plasma, den Meßwert des Gasflusses des Reaktivgases und den Meßwert der Kathodenleistung der Kathode durchgehend beobachten. Dies ist allerdings sehr aufwendig und personalintensiv, da die Einfahrzeit, z.B. bei Nickelchrom, mehrere Stunden betragen kann. Außerdem ist auch während des Sputterprozesses eine durchgehende Beobachtung erforderlich.

Ein Verfahren und eine Vorrichtung zum Beschichten eines Substrats ist außerdem aus der EP 0 502 242 A2 bekannt.

Der Erfindung liegt die Aufgabe zugrunde, eine Sputterbeschichtungsanlage und ein Verfahren zu deren Regelung bereitzustellen, bei denen der Gasfluß des Reaktivgases und die Kathodenleistung geregelt werden, um einen stabilen Betrieb der Sputterbeschichtungsanlage und insbesondere kurze Einfahrzeiten der Sputterbeschichtungsanlage zu erzielen.

Die Aufgabe wird durch eine Sputterbeschichtungsanlage mit den Merkmalen des Anspruchs 1 und durch ein Verfahren zur Regelung einer Sputterbeschichtungsanlage mit den Merkmalen des Anspruchs 14 gelöst. Vorteilhafte Weiterbildungen der in Anspruch 1 angegebenen Sputterbeschichtungsanlage sind durch die in den Ansprüchen 2 bis 13 angegebenen Maßnahmen möglich. Vorteilhafte Weiterbildungen des in Anspruch 14 angegebenen Verfahrens sind durch die in den Ansprüchen 15 bis 17 gegebenen Maßnahmen möglich.

Die erfindungsgemäße Sputterbeschichtungsanlage hat den Vorteil, daß der Gasfluß des Reaktivgases und die Kathodenleistung der Kathode basierend auf einer Fuzzy-Logik in Abhängigkeit von dem Gasfluß des Reaktivgases, der Kathodenleistung und der Anzahl der Einbrüche der Kathodenspannung, die infolge der Entladung der Kathode über das Plasma auftreten, erfaßt und mittels einer Regelschaltung geregelt sind. Dadurch kann die Anzahl der Einbrüche der Kathodenspannung beim Einfahren der Kathode, d.h. wenn die Leistung der Kathode nach dem Zünden des Plasmas auf den Betriebswert gefahren wird, ohne daß die Anzahl der Einbrüche der Kathodenspannung einen kritischen Wert übersteigt, in kurzer Zeit erfolgen, wobei das ausgebildete Plasma stets stabilisiert wird. Dabei werden die Anzahl der Einbrüche der Kathodenspannung ausgewertet und ab einer bestimmten Anzahl pro Zeit wird nach den Fuzzyregeln der Sauerstoff zurückgenommen. Außerdem zeichnet sich die erfindungsgemäße Sputterbeschichtungsanlage auch im Arbeitsbetrieb durch einen erheblich stabileren Betriebszustand aus.

Daher führt die erfindungsgemäße Sputterbeschichtungsanlage zu einer Verkürzung von Anlagenrüstzeiten, da Kathodeneinbrennzeiten und Schichteinfahrzeiten optimiert werden können. Außerdem lassen sich erhebliche Personalkosten einsparen, da alle Vorgänge automatisiert ablaufen. Außerdem können die optischen Schichteigenschaften des beschichteten Substrats gleichmäßiger ausgebildet werden, da die Ablagerung von Sputtermaterial auf Kammerwänden, Blenden und Transportrollen verringert ist. Da das Einbrennen der Kathoden mit einer Leistung in der Größenordnung von 100 kW erfolgt, kann durch die reduzierte Einbrennzeit der Energiebedarf außerdem erheblich reduziert werden.

Vorteilhaft ist es, daß die Regelschaltung eine Fuzzyfizierungseinheit umfaßt, die die Meßgrößen in fuzzyfizierte Signale umsetzt, daß die Fuzzyfizierungseinheit einen Gasfluß-Sollwertspeicher aufweist, der einen Sollwert für den Gasfluß des Reaktivgases bereitstellt, daß die Fuzzyfizierungseinheit den Istwert des Gasflusses mit dem Sollwert des Gasflusses zu einem Signal verrechnet und daß die Fuzzyfizierungseinheit das durch die Verrechnung erhaltene Signal fuzzyfiziert. Dadurch kann der Sollwert des Gasflusses vorgegeben werden, wobei bezüglich der Abweichung des Istwerts des Gasflusses von diesem eine Fuzzyfizierung erfolgt.

Vorteilhaft ist es ferner, daß das Prozeßleitsystem einen Kathodenleistung-Sollwertspeicher aufweist, der einen Sollwert für die Kathodenleistung bereitstellt, daß das Prozeßleitsystem den Istwert der Kathodenleistung mit dem Sollwert der Kathodenleistung zu einem Signal verrechnet, und daß die Fuzzyfizierungseinheit das durch die Verrechnung erhaltene Signal fuzzyfiziert. Dadurch kann der Sollwert der Kathodenleistung variabel vorgegeben werden, wobei eine Fuzzyfizierung des Istwerts der Kathodenleistung in Bezug auf den Sollwert der Kathodenleistung, insbesondere auf eine Abweichung von dem Sollwert der Kathodenleistung, erfolgt.

Ferner ist es vorteilhaft, daß das Prozeßleitsystem (oder eine Ablaufsteuerung) einen Zeitgeber aufweist, der ein Taktsignal erzeugt, daß das Prozeßleitsystem die Meßgröße, die die Einbrüche der Kathodenspannung angibt, mit dem Taktsignal zu einem Signal umsetzt, das die Anzahl der Einbrüche der Kathodenspannung pro Zeiteinheit angibt, und daß die Fuzzyfizierungseinheit das durch die Umsetzung erhaltene Signal fuzzyfiziert. Dadurch kann die zeitliche Dichte der Einbrüche der Kathodenspannung erfaßt werden. Dabei ist es außerdem möglich, eine zeitliche Mittelung über die Anzahl der Einbrüche der Kathodenspannung zu tätigen, um ein Ausbrechen der Regelung zu verhindern. Die Anzahl der Einbrücke der Kathodenspannung pro Zeiteinheit kann auch eine gemessene Größe sein.

In vorteilhafter Weise sind in dem Gasfluß-Sollwertspeicher eine Vielzahl von Sollwerten für den Gasfluß und in dem Kathodenleistung-Sollwertspeicher eine Vielzahl von Sollwerten für die Kathodenleistung hinterlegt, wobei einer bestimmten Einfahrzeit genau ein Sollwert für den Gasfluß und genau ein Sollwert für die Kathodenleistung zugeordnet sind, und stellen die Sollwertspeicher die Sollwerte bereit, die dieser Einfahrzeit zugeordnet sind, wenn das Taktsignal des Zeitgebers die vorbestimmte Einfahrzeit erreicht. Dadurch können in dem Gasfluß-Sollwertspeicher und in dem Kathodenleistung-Sollwertspeicher Einfahrkurven zum Einfahren der Sputterbeschichtungsanlage hinterlegt werden, die für vorbestimmte Einfahrzeiten vordefinierte Sollwerte für den Gasfluß des Reaktivgases und die Kathodenleistung der Kathode angeben. Je nach Targetmaterial können bestimmte Einfahrkurven in die Sollwertspeicher eingespeichert werden, wodurch ein Umrüsten der Sputterbeschichtungsanlage auf ein anderes Targetmaterial erheblich vereinfacht wird. Die hinterlegten Einfahrkurven können aufgrund der bisherigen Anlagenerfahrung der Anlagenfahrer, experimentell ermittelter Meßprotokollen und ähnlichem erhalten werden. Eine Abänderung der eingespeicherten Sollwerte und somit eine Angleichung der Einfahrkurven an die eingerichtete Sputterbeschichtungsanlage kann jederzeit durch das Bedienpersonal oder auch durch die Regelschaltung selbst vorgenommen werden. Die Sollwerte können dabei sowohl zeitlich äquidistant als auch beliebig beabstandet sein. Beispielsweise können in Bereichen, in denen das erzeugte Plasma prozeßbedingt stabil ist, größere zeitliche Abstände zwischen den Sollwerten vorgesehen sein, während in prozeßkritischen Bereichen, in denen die Prozeßparameter genau geführt werden müssen, in kurzen zeitlichen Abständen, mittels Interpolation gegebenenfalls sogar kontinuierlich, Sollwerte vorgegeben werden. Erreicht das Taktsignal des Zeitgebers eine der vorbestimmten Einfahrzeiten, dann stellt der Sollwertspeicher den dieser Einfahrzeit zugeordneten Sollwert solange bereit, bis die nächste vorbestimmte Einfahrzeit erreicht wird.

Vorteilhaft ist es, daß die Regelschaltung eine Kontrolleinheit aufweist, daß der Gasfluß-Sollwertspeicher den Sollwert für den Gasfluß und der Kathodenleistung-Sollwertspeicher den Sollwert für die Kathodenleistung nur erneuern, wenn die Kontrolleinheit ein Freigabesignal ausgibt, und daß die Kontrolleinheit das Freigabesignal ausgibt, wenn der gemessene Istwert des Gasflusses des Reaktivgases innerhalb eines vorgegebenen Bereichs um den Sollwert des Gasflusses liegt und der gemessene Istwert der Kathodenleistung innerhalb eines vorgegebenen Bereichs um den Sollwert der Kathodenleistung liegt. Dadurch wird im Extremfall ein Weglaufen der Regelung von den tatsächlichen Prozeßparametern verhindert, da die Kontrolleinheit das Freigabesignal, aufgrund dessen neue Sollwerte für den Gasfluß des Reaktivgases und die Kathodenleistung ausgegeben werden, nur ausgibt, wenn die gemessenen Istwerte die Sollwerte erreichen. Dadurch kann auch der Einfluß von externen bzw. Beschichtungsprozeß-bedingten Schwankungen, gedämpften Anpassungsvorgängen und dergleichen eliminiert werden.

In vorteilhafter Weise umfaßt die Regelschaltung eine Inferenzeinheit, die die fuzzyfizierten Signale aufgrund von Fuzzyregeln miteinander verknüpft, um fuzzyfizierte Ergebnissignale für den Gasfluß des Reaktivgases und die Kathodenleistung zu erhalten. Durch die Inferenzeinheit können die fuzzyfizierten Signale, auch wenn diese von einander widersprechenden Inhaltes sind, überlagert werden, so daß auch komplexe Prozeßzustände aufgelöst werden können. Zum Beispiel kann, wenn die Anzahl der Entladungen der Kathode über das Plasma gering ist und sowohl eine Erhöhung des Gasflusses des Reaktivgases als auch eine Erhöhung der Kathodenleistung möglich ist, zuverlässig entschieden werden, um wieviel sowohl der Gasfluß des Reaktivgases als auch die Kathodenleistung gleichzeitig erhöht werden können, ohne daß der Einfahrprozeß destabilisiert wird. Die Fuzzy-Logik ist hier einem Anlagenfahrer deutlich überlegen, da sie auch größere Änderungen des Gasflusses des Reaktivgases und der Kathodenleistung vornehmen kann. Außerdem kann dadurch auch in kritischen Prozeßzuständen zuverlässig und schnell die richtige Entscheidung getroffen werden.

Vorteilhaft ist es, daß die Regelschaltung eine Defuzzyfizierungseinheit, die die fuzzyfizierten Ergebnissignale in diskrete Ergebnissignale defuzzyfiziert, und ein Prozeßleitsystem umfaßt, das überwacht, ob die Ergebnissignale in vorgegebenen Bereichen liegen und, falls zumindest ein Ergebnissignal außerhalb des zugeordneten vorgegebenen Bereichs liegt, dieses auf einen vorgegebenen Maximal- bzw. Minimalwert begrenzt, wobei der Gasfluß des Reaktivgases und die an der Kathode anliegende Kathodenspannung unter Berücksichtigung der Ergebnissignale neu eingestellt werden. Durch das Prozeßleitstystem wird sichergestellt, daß der in der Sputterbeschichtungsanlage laufende Prozeß nicht durch zu große durch die Ergebnissignale bedingte Änderungen des Gasflusses des Reaktivgases und/oder der Kathodenspannung der Kathode beeinträchtigt wird.

Vorteilhaft ist es ferner, daß das Prozeßleitsystem, falls zumindest eines der Ergebnissignale den vorgegebenen Bereich überschritten hat, ein Fehlersignal erzeugt, das eine Bereichsüberschreitung des Ergebnissignals anzeigt. Durch das Fehlersignal kann einem Operator, insbesondere einer Bedienperson, die Bereichsüberschreitung angezeigt werden, woraufhin dieser einen Eingriff in die Regelung vornehmen kann. Das erzeugte Fehlersignal kann auch zur Protokollierung des Einfahr- bzw. Beschichtungsprozesses verwendet werden, um insbesondere auf die vorgegebenen Sollwerte Einfluß zu nehmen.

Vorteilhaft ist es ferner, daß die Kontrolleinheit, falls das Prozeßleitsystem ein Fehlersignal erzeugt, solange kein Freigabesignal, das die Erneuerung des Gasfluß-Sollwertes und des Kathodenleistung-Sollwertes freigibt, ausgibt, bis durch einen Operator, insbesondere eine Bedienperson, die Ausgabe wieder freigegeben ist. Dadurch kann, insbesondere bei kritischen Prozessen, eine Erneuerung der Sollwerte verhindert werden, um den Prozeß auf die gegebenen Sollwerte zu stabilisieren, wobei die erneute Freigabe im Ermessen des Operators liegt. Wird die Sputterbeschichtungsanlage von einer Bedienperson überwacht, dann ergibt sich außerdem der Vorteil, daß, wenn an mehreren Sputterkammern oder Kathoden der Gesamtsputteranlage, die das gesamte Schichtsystem auf das Substrat aufbringt, und/oder an mehreren Sputterbeschichtungsanlagen zur gleichen Zeit Fehlersignale erzeugt werden, die Bedienperson die Fehler der einzelnen Sputterkammern oder Kathoden der Gesamtsputteranlage und/oder der einzelnen Sputterbeschichtungsanlagen nacheinander abarbeiten kann.

Vorteilhaft ist es, daß, falls das Prozeßleitsystem ein Fehlersignal erzeugt und durch den Operator die Ausgabe des Freigabesignals der Kontrolleinheit freigegeben ist, die Kontrolleinheit das Freigabesignal sogar dann ausgibt, wenn eines oder mehrere der Ergebnissignale weiterhin außerhalb der vorgegebenen Bereiche liegen. Dadurch kann der Operator, insbesondere bei unkritischen Prozessen, erzwingen, daß der Einfahr- bzw. Beschichtungsprozeß unbeeinflußt fortgesetzt wird.

Das erfindungsgemäße Verfahren zur Regelung einer Sputterbeschichtungsanlage hat den Vorteil, daß sowohl die Kathodeneinfahrzeit und die Schichteinfahrzeit der Sputterbeschichtungsanlage verkürzt werden können, als auch die optischen Eigenschaften, insbesondere Transmission, Reflexion und Infrarotreflexion, der mit der Sputterbeschichtungsanlage beschichteten Substrate eine höhere Güte aufweisen. Dabei wird ein kritischer Zustand des zwischen Kathode und Anode ausgebildeten Plasmas von vornherein verhindert, da die Anzahl der Einbrüche der Kathodenspannung unter Anwendung der Fuzzyregeln laufend überwacht wird und in die Regelung des Gasflusses des Reaktivgases und der Kathodenleistung der Kathode eingeht.

Vorteilhaft ist es, daß die Anzahl der Einbrüche der Kathodenleistung unter Verwendung eines Taktsignals in ein Signal umgesetzt wird, das die Anzahl der Einbrüche der Kathodenleistung pro Zeiteinheit angibt, und daß dieses Signal bezüglich der linguistischen Variablen "wenig", "mittel" und "viel" fuzzyfiziert wird; daß der Istwert des Gasflusses des Reaktivgases von einem Sollwert des Gasflusses des Reaktivgases abgezogen wird und das Ergebnis bezüglich der linguistischen Variablen "negativ", "Null" und "positiv" zu einem fuzzyfizierten Signal fuzzyfiziert wird; daß der Istwert der Kathodenleistung von einem Sollwert der Kathodenleistung abgezogen wird und das Ergebnis bezüglich der linguistischen Variablen "negativ", "Null" und "positiv" zu einem fuzzyfizierten Signal fuzzyfiziert wird; daß die fuzzyfizierten Signale gemäß vorgegebenen Fuzzyregeln miteinander verknüpft werden, wodurch ein bezüglich der linguistischen Variablen "senken", "halten" und "erhöhen" fuzzyfiziertes Ergebnissignal für den Gasfluß des Reaktivgases und ein bezüglich der linguistischen Variablen "senken", "halten" und "erhöhen" fuzzifiziertes Ergebnissignal für die Kathodenleistung erhalten werden; und daß die fuzzyfizierten Ergebnissignale auf diskrete Ergebnissignale defuzzyfiziert werden. Das fuzzyfizierte Signal, das sich aus der Differenz von dem Sollwert des Gasflusses des Reaktivgases und des Istwerts des Gasflusses des Reaktivgases ergibt, das fuzzyfizierte Signal, das sich aus der Differenz von dem Sollwert der Kathodenleistung und dem Istwert der Kathodenleistung ergibt, und das fuzzyfizierte Signal, das sich aus der Anzahl der Einbrüche der Kathodenleistung pro Zeiteinheit ergibt, werden mittels Fuzzyregeln zum Erhalten der fuzzyfizierten Ergebnissignale miteinander überlagert bzw. zur Inferenz gebracht, wobei vorgegebene Fuzzyregeln die Verknüpfung der fuzzyfizierten Signale vorgeben. In vorteilhafter Weise umfassen die Fuzzyregeln dabei folgende Regeln: Die Verknüpfung von "wenig" und "positiv" wird auf "erhöhen" abgebildet, die Verknüpfung von "wenig" und "Null" wird auf "halten" abgebildet, die Verknüpfung von "wenig" und "negativ" wird auf "senken" abgebildet, "mittel" wird auf "halten" abgebildet, und "viel" wird auf "senken" abgebildet. Im Rahmen der Fuzzy-Logik kann die Verknüpfung, die insbesondere als UND-Verknüpfung bezeichnet wird, je nach Prozeß definiert werden. Zum Beispiel kann durch die Wahl der Verknüpfung eine eher prozeßstabilisierende oder eine eher prozeßbeschleunigende Vorgabe für die Ergebnissignale erreicht werden. Für kritische Prozesse wird in vorteilhafter Weise die Verknüpfung der Zugehörigkeitsgrade zu den linguistischen Variablen mittels der Minimumsfunktion definiert. Die Minimumsfunktion ist so definiert, daß sie zwei reelle Zahlen, insbesondere zwei Zahlen zwischen O und 1, auf die kleinere der beiden Zahlen abbildet. Die UND-Verknüpfung kann auch anders definiert werden, insbesondere durch UND (a, b) = ab/(a+b-ab) oder durch UND (a, b) = (ab)^{1-λ}(1-(1-a)(1-b))^{λ}. Dabei ist die letzte Verknüpfung das kompensierende UND, das für λ = 0 bis 1 zwischen UND und ODER interpoliert. Durch das kompensierende UND kann dem Erfahrungswissen der Anlagenfahrer besser entsprochen werden, da dies der sprachlichen Ausdrucksweise näher kommt. Wenn beispielsweise der unscharfe Begriff "Gasfluß erhöhen" definiert wird durch "Anzahl der Einbrüche pro Zeiteinheit wenig" UND "Sollwert - Istwert Gasfluß positiv", dann ist implizit gemeint, daß eine etwas geringere Anzahl der Einbrüche pro Zeiteinheit den Effekt von einem etwas größeren Istwert des Gasflusses aufwiegen kann und umgekehrt. Das kompensierende UND ist ein Mittelding zwischen dem logischen UND und dem logischen ODER, das diesem sprachlichen Gebrauch Rechnung trägt. Für λ = 0 ergibt sich die Minimumsfunktion, während für λ = 1 das kompensierende UND zur Maximumsfunktion, also dem logischen ODER wird. Zwischenwerte von λ interpolieren zwischen UND und ODER, so daß eine Anpassung des kompensierenden UNDs möglich ist.

Ausführungsbeispiele der Erfindung sind anhand der nachfolgenden Beschreibung unter Bezugnahme auf die Zeichnungen näher beschrieben. Es zeigen:
- Fig. 1: ein Ausführungsbeispiel einer Sputterbeschichtungsanlage;
- Fig. 2: die in Fig. 1 dargestellte Sputterbeschichtungsanlage in einem Blockschaltbild;
- Fig. 3: die in Fig. 2 dargestellte Fuzzyfizierungseinheit im Detail;
- Fig. 4a bis 4c: Teile des in Fig. 3 dargestellten Fuzzyfizierungsglieds der Fuzzyfizierungseinheit im Detail;
- Fig. 5: ein Detail der in Fig. 2 dargestellten Inferenzeinheit;
- Fig. 6a und 6b: Teile der in Fig. 2 dargestellten Defuzzyfizierungseinheit im Detail; und
- Fig. 7: einen Signalflußplan zur Darstellung eines Verfahrens zur Regelung einer Sputterbeschichtungsanlage gemäß einem weiteren Ausführungsbeispiel.

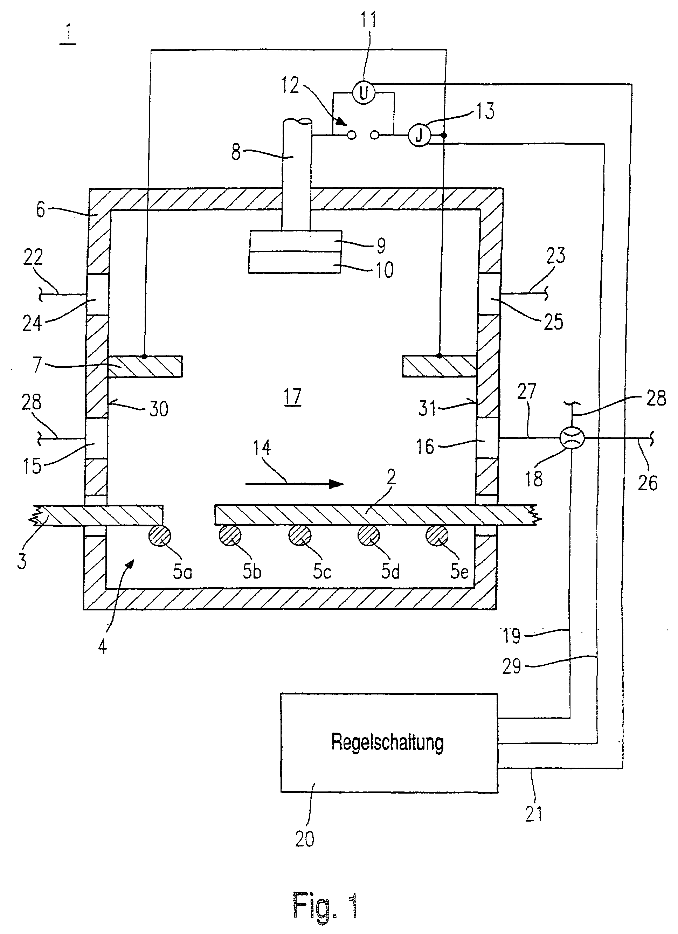

Fig. 1 zeigt eine Sputterbeschichtungsanlage 1, die zur Beschichtung von Substraten 2, 3, insbesondere Glasscheiben, dient. Die Sputterbeschichtungsanlage 1 weist in dem beschriebenen Ausführungsbeispiel eine Transporteinrichtung 4 auf, die die Transportrollen 5a bis 5e umfaßt, so daß eine Vielzahl von Substraten 2, 3 aufeinanderfolgend beschichtet werden kann. Die erfindungsgemäße Sputterbeschichtungsanlage eignet sich allerdings auch zum Beschichten von einzelnen Substraten.

Die Sputterbeschichtungsanlage 1 weist ein Gehäuse 6 und eine mit dem Gehäuse 6 mechanisch verbundene, als Anodenblende ausgebildete Anode 7 auf, die gegenüber dem Gehäuse 6 elektrisch isoliert ist. Das Gehäuse 6 ist mit einer gegenüber diesem elektrisch isolierten Kathodenhalter 8 verbunden, der eine Kathode 9 hält. An die Kathode 9 ist ein Sputtertarget 10 befestigt. Die Kathode 9 wird gegenüber der Anode 7 mit einer Spannung U beaufschlagt, die sowohl durch eine Gleich-, Mittelfrequenz-, Puls-, eine Hochfrequenzspannung oder dergleichen gegeben sein kann. Die Spannung U wird von einem Spannungsmeßgerät 11 gemessen, das parallel zu der die Kathode versorgenden Spannungsquelle 12 geschalten ist. Zwischen die Spannungsquelle 12 und die Anode 7 ist ein Strommeßgerät 13 geschaltet, das den Kathoden- bzw. Anodenstrom mißt. Das Strommeßgerät 13 kann auch zwischen die Kathode 9 und die Spannungsquelle 12 geschaltet sein.

Mittels des Spannungsmeßgeräts 11 und des Strommeßgeräts 13 können die Kathodenspannung und der Kathodenstrom gemessen werden, woraus sich die Kathodenleistung ermitteln läßt. Beispielhafte Werte sind 0 bis 600 V für die Kathodenspannung und 0 bis 70 A für den Kathodenstrom. Die Spannungsquelle 12 kann dabei beispielsweise für maximal 40 kW ausgelegt sein, so daß die Kathode 9 mit maximal 40 kW versorgt wird. Die Anode 7 ist nicht notwendigerweise mit der Masse verbunden und kann mit einer positiven Anodenspannung versorgt werden, die z.B. zwischen 0 und 80 V bei einem Anodenstrom von 0 bis 70 A liegt.

In den Raum zwischen der Kathode 9 bzw. dem Sputtertarget 10 und der Anode 7 wird als Arbeitsgas ein Inertgas, beispielsweise Argon, geleitet. Durch Anlegen der Kathodenspannung zwischen Kathode und Anode zündet zum Bewirken des Sputterprozesses ein Plasma. Dieses entsteht, wenn durch Zusammenstöße mit Elektronen schwere, positiv geladene Ionen aus den Atomen des Inertgases erzeugt werden. Die hohe Spannung erzeugt ein starkes elektrisches Feld, das die schweren, positiv geladenen Ionen zur Kathode hin beschleunigt. Beim Betrieb des Plasmas herrscht im Bereich des Plasmas beispielsweise ein Druck von 1 · 10⁻³ bis 5 · 10⁻³ mbar bei einem Druck des Restgases von 10⁻⁵ mbar, ohne Berücksichtigung eines eventuellen Reaktivgasflusses. Die entstandenen schweren, positiv geladenen Ionen werden auf die negativ geladene Kathode 9 zu beschleunigt, auf der das aus dem Beschichtungsmaterial bestehende Sputtertarget 10 befestigt ist. Die mit hoher Energie auftreffenden Ionen schlagen aus dem Sputtertarget 10 Material heraus, das sich anschließend auf den Substraten 2 bzw. 3 niederschlägt. In Abhängigkeit von der Beschichtungsrate und der Transportgeschwindigkeit der Substrate 2, 3 in der Transportrichtung 14, die durch den Transport mittels der Transportrollen 5a bis 5e erreicht wird, scheidet sich auf den Substraten 2, 3 eine aus dem Material des Sputtertargets 10 bestehende dünne Schicht von vorgegebener Schichtdicke ab. Indem die Substrate 2, 3 mehrere der beschriebenen Sputterkammern durchlaufen, kann auf den Substraten 2, 3 ein beliebiges Schichtsystem ausgebildet werden.

Die Sputterbeschichtungsanlage 1 dient insbesondere zum Sputtern von Targetmaterialien in einer Reaktivgasatmosphäre, die z.B. aus Sauerstoffgas oder Stickstoffgas besteht. Das Reaktivgas wird dabei durch einen Gaseinlaß 15, 16 in den Raum 17 zwischen der Anode 7 und den Substraten 2, 3 geleitet. Der Gasfluß des Reaktivgases wird dabei über zumindest einen Gasflußregler oder Massflowmeter 18 regelt, wobei der Gasfluß über eine Leitung 19 an eine Regelschaltung 20 gemeldet wird. Die Regelschaltung 20 erfaßt außerdem über die Leitung 29 den Kathodenstrom, der von dem Strommeßgerät 13 gemessen wird, und über die Leitung 21 die Kathodenspannung, die von dem Spannungsmeßgerät 11 gemessen wird. Aufgrund des Gasflusses des Reaktivgases, und der durch die Kathodenspannung und den Kathodenstrom gemessenen Kathodenleistung regelt die Regelschaltung 20 den Gasfluß mittels einer Drossel, die in der Drosseleinheit 18 vorgesehen ist, und die Kathodenspannung mittels der Spannungsquelle 12, wobei die Meßgröße, die die Einbrüche der Kathodenspannung, die infolge Entladung der Kathode 9 über das Plasma auftreten, erfaßt, durch das von dem Spannungsmeßgerät 11 über die Leitung 21 erfaßten Meßsignal ermittelt wird. Dadurch können abhängig von dem Erfahrungswissen mit verschiedensten Materialien Fuzzyregeln aufgestellt werden und diese können relativ einfach mit der Fuzzyeinheit in die Regeltechnik umgesetzt werden. Dieser Vorteil wächst überproportional, wenn mehr als eine Regelgröße vorliegt (nicht linearer Regler).

Um das zum Funktionieren des Sputterprozesses, insbesondere im Raum 17, benötigte Vakuum zu schaffen, ist ein Pumpsystem vorgesehen, das den Innenraum des Gehäuses 6 über Gasleitungen 22, 23 durch in dem Gehäuse 6 vorgesehene Gasaustrittsöffnungen 24, 25 auspumpt.

Das Reaktivgas wird über die Gasleitung 26 zu der Drosseleinheit 18 und von dort über die Gasleitungen 27, 28 zu den Gaseinlässen 15, 16 des Gehäuses 6 der Sputterbeschichtungsanlage 1 geleitet.

Das zum Auspumpen des Gehäuses 6 der Sputterbeschichtungsanlage 1 verwendete Pumpsystem kann z.B. aus einer Anordnung von mehreren Turbomolekularpumpen, die an geeignete Vorpumpen angeschlossen sind, bestehen.

In dem beschriebenen Ausführungsbeispiel ist die Anode 7 als Anodenblende ausgebildet, wobei sie zur elektrischen Stabilisierung des Plasmas dient. Dadurch kann die Eigenschaft der aufgesputterten Schicht verbessert werden, insbesondere wird eine gleichmäßige Schichtdicke und eine hohe Homogenität erreicht.

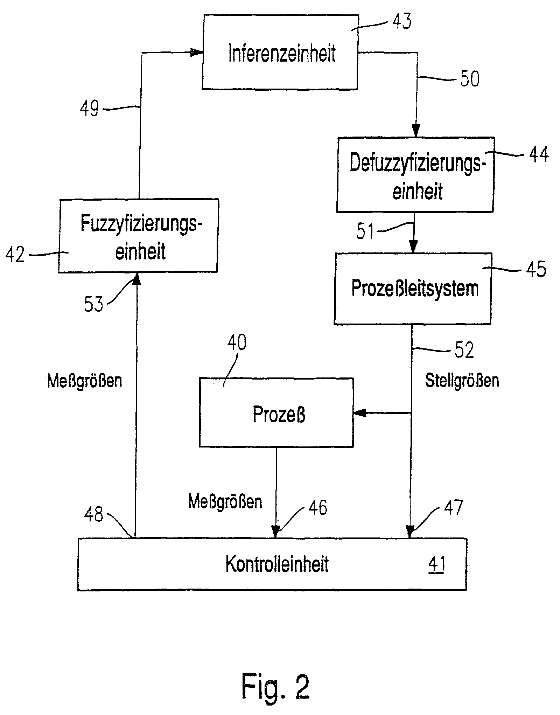

Fig. 2 zeigt die anhand der Fig. 1 beschriebene Sputterbeschichtungsanlage in einer schematischen Darstellung, wobei Teile der Regelschaltung 20 aufgegliedert dargestellt sind. Bereits beschriebene Elemente sind in dieser und in allen anderen Figuren mit übereinstimmenden Bezugszeichen versehen, wodurch sich eine wiederholende Beschreibung erübrigt.

In der Sputterbeschichtungsanlage 1 wird zum Einfahren der Kathode 9 und zum Beschichten der Substrate 2, 3 ein Prozeß 40 durchgeführt, der durch eine Reihe von Prozeßparametern definiert ist. Prozeßparameter sind z.B. die Einbrüche der Kathodenspannung (ARC), die infolge Entladung der Kathode über das Plasma auftreten, der Gasfluß des Reaktivgases bzw. die in dem Raum 17 absolut vorhandene Menge des Reaktivgases und die Kathodenspannung der Kathode 9. Die Prozeßparameter des Prozesses 40 werden gemessen und an die Kontrolleinheit 41 der Regelschaltung 20 übergeben. Die Meßgrößen umfassen die Meßgröße, die den Gasfluß des Reaktivgases angibt, die Meßgröße, die die Kathodenleistung angibt, und die Meßgröße, die die Einbrüche der Kathodenspannung, die infolge Entladung der Kathode über das Plasma auftreten, angibt. Die Meßgrößen werden mittels mehrerer Einheiten 42 bis 45 verarbeitet, wodurch Stellgrößen erhalten werden, die die Prozeßparameter des Prozesses 40 beeinflussen. Hierzu werden die Stellgrößen, die den Sollwert des Gasflusses des Reaktivgases und den Sollwert der Kathodenleistung der Kathode 9 umfassen, zum Einstellen des Gasflusses des Reaktivgases mittels der Drossel der Drosseleinheit 18 und der Kathodenspannung der Spannungsquelle 12 verwendet. Dabei werden von der Kontrolleinheit 41 fortlaufend die Meßgrößen des Prozesses 40 aufgrund der vorliegenden Prozeßparameter erfaßt und mit den Stellgrößen, die die Sollwerte angeben, verglichen, wobei die Kontrolleinheit 41 die Ermittlung neuer Stellgrößen durch die Einheiten 42 bis 45 freigibt, wenn die bestehenden Meßgrößen in geeigneter Beziehung zu den ermittelten Sollgrößen stehen. Die Kontrolleinheit 41 umfaßt dazu einen Eingang 46, über den die aus den Prozeßparametern des Prozesses 40 ermittelten Meßgrößen übergeben werden, und einen Eingang 47, über den die Stellgrößen von dem Prozeßleitsystem 45 übergeben werden. Außerdem umfaßt die Kontrolleinheit einen Ausgang 48 zur Übergabe der Meßgrößen an die Fuzzyfizierungseinheit 42.

Die Fuzzyfizierungseinheit 42 ist mittels der Signalleitung 49 mit der Inferenzeinheit 43 verbunden, die mittels einer weiteren Signalleitung 50 mit der Defuzzyfizierungseinheit 44 verbunden ist. Die Defuzzyfizierungseinheit 44 ist wiederum mittels einer Signalleitung 51 mit dem Prozeßleitsystem 45 verbunden. Das Prozeßleitsystem 45 gibt die von den Einheiten 42 bis 45 ermittelten Stellgrößen mittels der Verbindung 52 zum einen an den Prozeß 40 und zum anderen an die Kontrolleinheit 41 weiter.

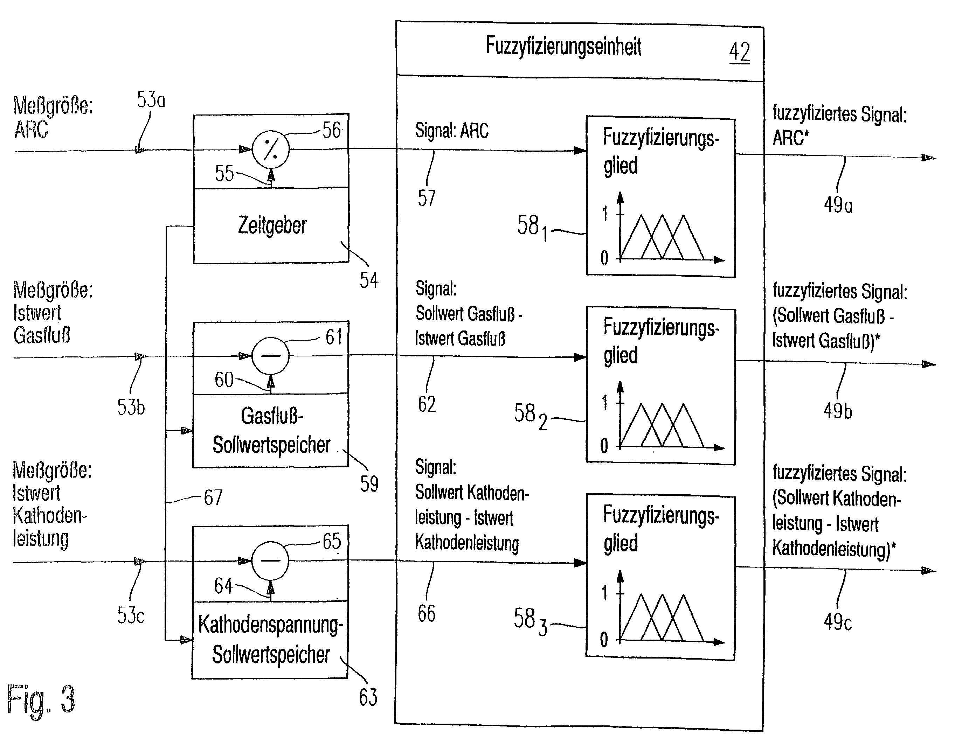

Fig. 3 zeigt die in Fig. 2 dargestellte Fuzzyfizierungseinheit 42 im Detail.

Die Fuzzyfizierungseinheit 42 weist die Eingänge 53a bis 53c auf, die in Fig. 2 zu dem Eingang 53 zusammengefaßt sind. Über den Eingang 53a wird die Meßgröße ARC, d.h. die Meßgröße, die die Einbrüche der Kathodenspannung, die infolge Entladung der Kathode über das Plasma auftreten, erfaßt, an die Fuzzyfizierungseinheit 42 übertragen. Über den Eingang 53b wird die Meßgröße, die den Istwert des Gasflusses angibt, und über den Eingang 53c wird die Meßgröße, die den Istwert der Kathodenleistung angibt, an die Fuzzyfizierungseinheit 42 übergeben.

Ferner ist ein Zeitgeber 54 vorgesehen, der ein Taktsignal erzeugt und dieses über eine Signalleitung 55 an eine Verrechnungseinheit 56 abgibt. Die Verrechnungseinheit 56 verrechnet die erfaßte Meßgröße ARC durch Division mit dem Taktsignal zu einem Signal ARC, das die Anzahl der Einbrüche der Kathodenspannung pro Zeiteinheit angibt, wobei dieses Signal von der Verrechnungseinheit 46 über die Signalleitung 57 an ein Fuzzyfizierungsglied geleitet wird. Das Fuzzyfizierungsglied 58 fuzzyfiziert das Signal ARC, das die Anzahl der Einbrüche der Kathodenspannung pro Zeiteinheit angibt, zu einem fuzzyfizierten Signal ARC* und gibt dieses über eine Signalleitung 49a aus.

Über den Eingang 53b der Fuzzyfizierungseinheit 42 wird die Meßgröße, die den Istwert des Gasflusses des Reaktivgases angibt, an die Fuzzyfizierungseinheit 42 übergeben. Ferner ist ein Gasfluß-Sollwertspeicher 59 vorgesehen, der einen Sollwert für den Gasfluß bereitstellt und über die Signalleitung 60 an die Verrechnungseinheit 61 übergibt. Die Verrechnungseinheit 61 zieht von dem vom Gasfluß-Sollwertspeicher 59 vorgegebenen Sollwert des Gasflusses des Reaktivgases den Istwert des Gasflusses des Reaktivgases ab und übermittelt das erhaltene Signal, das die Differenz zwischen dem Sollwert und dem Istwert des Gasflusses des Reaktivgases angibt, über die Signalleitung 62 an das Fuzzyfizierungsglied 58. Das Fuzzyfizierungsglied 58 fuzzyfiziert dieses Signal zu einem fuzzyfizierten Signal und gibt dieses über die Signalleitung 49b aus.

Über den Eingang 53c der Fuzzyfizierungseinheit 42 wird die Meßgröße, die den Istwert der Kathodenleistung angibt, an die Fuzzyfierungseinheit 42 übergeben. Ferner ist ein Kathodenleistung-Sollwertspeicher 63 vorgesehen, der einen Sollwert für die Kathodenleistung der Kathode 9 über eine Signalleitung 64 für eine Verrechnungseinheit 65 bereitstellt. Die Verrechnungseinheit 65 subtrahiert den Istwert der Kathodenleistung von dem Sollwert der Kathodenleistung und gibt das Ergebnis in Form eines Ergebnissignals über die Signalleitung 66 an das Fuzzyfizierungsglied 58 aus. Das Fuzzyfizierungsglied 58 fuzzyfiziert dieses Signal zu einem fuzzyfizierten Signal, das über die Signalleitung 49c ausgegeben wird. Der Kathodenleistung-Sollwertspeicher 63 liegt in Form einer Tabelle vor, wobei die Sollwerte für die Kathodenleistung in Abhängigkeit einer Prozeßzeit linear interpoliert werden können.

Die Signalleitung 49a - 49c sind die Ausgangsleitungen der Fuzzyfizierungseinheit 42, die in der Fig. 2 zu der Signalleitung 49 zusammengefaßt sind. Die fuzzyfizierten Signale, die über die Signalleitungen 49a - 49c bzw. die Signalleitung 49 von der Fuzzyfizierungseinheit 42 ausgegeben werden, werden an die Interferenzeinheit 43 übergeben.

In dem Gasfluß-Sollwertspeicher 59 und dem Kathodenleistung-Sollwertspeicher 63 sind eine Vielzahl von Sollwerten hinterlegt, die vorbestimmten Einfahrzeiten zugeordnet sind. Dadurch sind Einfahrkurven hinterlegt, die ein zeitgesteuertes Einfahren der Sputterbeschichtungsanlage 1 ermöglichen. Dabei ist jeder vorgegebenen Einfahrzeit genau ein Sollwert für den Gasfluß und/oder genau ein Sollwert für die Kathodenleistung zugeordnet. Erreicht das Taktsignal des Zeitgebers 54, das über die Signalleitung 67 sowohl an den Gasfluß-Sollwertspeicher 59 als auch an den Kathodenleistung-Sollwertspeicher 63 übermittelt wird, eine der vorbestimmten Einfahrzeiten, dann stellen die Sollwertspeicher 59, 63 die Sollwerte bereit, die dieser Einfahrzeit zugeordnet sind. Es ist auch möglich, daß einer vorbestimmten Einfahrzeit nur ein Sollwert für den Gasfluß aber kein Sollwert für die Kathodenleistung zugeordnet ist, dann wird lediglich der Sollwert für den Gasfluß bei Erreichen dieser Einfahrzeit aktualisiert, während der Sollwert für die Kathodenleistung beibehalten wird. Entsprechendes gilt auch, wenn der vorbestimmten Einfahrzeit lediglich ein Sollwert für die Kathodenleistung zugeordnet ist.

Die neuen Sollwerte, die von den Sollwertspeicher 59, 63 bereitgestellt werden, werden von den Verrechnungseinheiten 61, 65 so lange zur Verrechnung herangezogen, bis diese durch neue Sollwerte ersetzt werden. In den Sollwertspeicher 59, 63 sind eine Vielzahl von Einfahrkurven abgelegt, die in Abhängigkeit von dem Targetmaterial des Sputtertargets 10 und dem Reaktivgas ausgewählt werden. Dadurch wird der Wechsel des Targetmaterials des Sputtertargets 10 erheblich vereinfacht, da die jeweils benötigte Einfahrkurve bereits bereit steht.

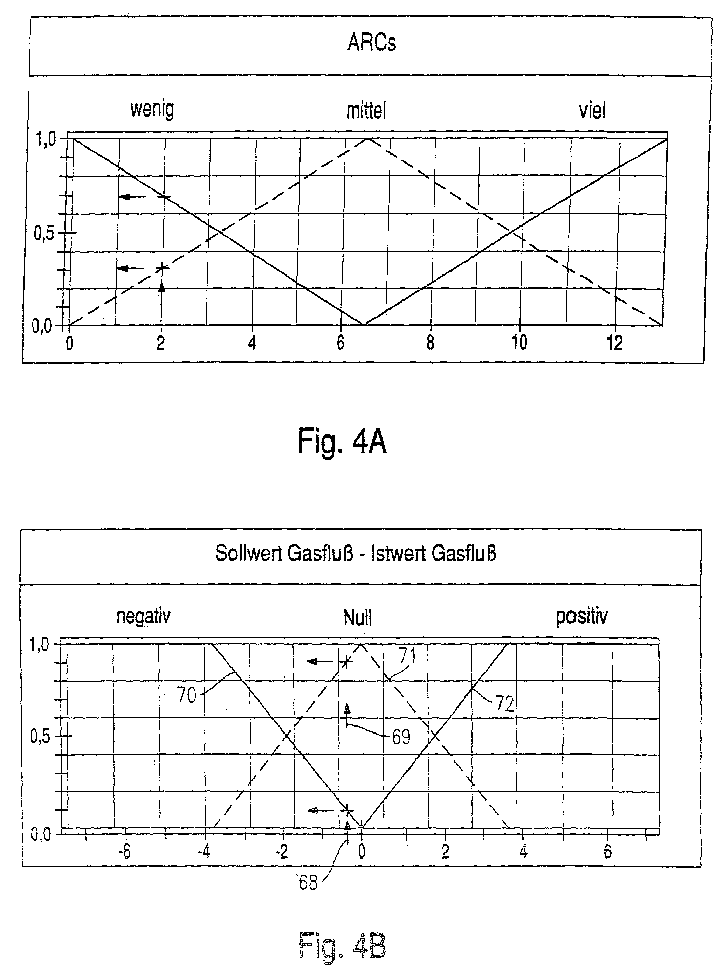

Im folgenden wird anhand der Fig. 4A - 4C die Fuzzyfizierungseinheit 42, insbesondere deren Fuzzyfizierungsglied 58, näher erläutert. Zur Veranschaulichung werden hierfür beispielhafte Signale verwendet, die in willkürlichen Einheiten angegeben sind.

Die in Fig. 2 dargestellte Kontrolleinheit 41 ermittelt aus der Kathodenspannung die Meßgröße, die die Einbrüche der Kathodenspannung, die in Folge der Entladung der Kathode über das Plasma auftreten, angibt, und leitet diese an die Fuzzyfizierungseinheit 42 weiter. Mittels des Zeitgebers 54 und der Verrechnungseinheit 56 wird diese Meßgröße zu einem Signal umgesetzt, das die Anzahl der Einbrüche der Kathodenspannung pro Zeiteinheit angibt. Dieses Signal wird in dem Fuzzyfizierungsglied 58₁ fuzzyfiziert. Wie in Fig. 4A dargestellt, sind drei Fuzzymengen vorgesehen, bezüglich der das Signal ARC in "wenig", "mittel" und "viel" zerlegt wird. Ist beispielsweise die Größe des Signals gleich 2, dann ist der Zugehörigkeitsgrad zu "wenig" gleich 0,7 = 70% und der Zugehörigkeitsgrad zu "mittel" gleich 0,3 = 30%, während der Zugehörigkeitsgrad zu "viel" gleich 0 ist.

Die 'in Fig. 2 dargestellte Kontrolleinheit 41 übergibt der Fuzzyfizierungseinheit 42 außerdem die Meßgröße, die den Istwert des Gasflusses des Reaktivgases angibt. Die Verrechnungseinheit 61 erzeugt das Signal, das die Differenz aus dem Sollwert des Gasflusses und dem Istwert des Gasflusses angibt, und sendet dieses an das Fuzzyfizierungsglied 58₂ zur Fuzzyfikation. Dieses Signal wird in dem Fuzzyfizierungsglied 58₂, wie in Fig. 4B dargestellt, bezüglich der linguistischen Variablen "negativ", "Null" und "positiv" zerlegt, wodurch die jeweiligen Zugehörigkeitsgrade zu den Fuzzymengen ermittelt werden. Liegt beispielsweise der Istwert des Gasflusses des Reaktivgases um 0,4 Einheiten unterhalb des Sollwertes des Gasflusses des Reaktivgases, dann ergibt sich für den Zugehörigkeitsgrad zu "negativ" 10%, den Zugehörigkeitsgrad zu "Null" 90% und für den Zugehörigkeitsgrad zu "positiv" 0%. Diese Werte werden erhalten, indem vom Abszissenwert -0,4 (Bezugszeichen 68) aus in der Richtung 69, die parallel zur Ordinate ist, die Schnittpunkte mit der "negativ"-Kurve 70, der "Null"-Kurve 71 und der "positiv"-Kurve 72 ermittelt werden. Der Schnittpunkt mit der "negativ"-Kurve 70 ergibt 0,1 = 10% und der Schnittpunkt mit der "Null"-Kurve 71 ergibt 0,9 = 90%. Da sich mit der "positiv"-Kurve 72 kein Schnittpunkt ergibt, ist der zugeordnete Zugehörigkeitsgrad gleich 0%.

Die in Fig. 4B dargestellte "negativ"-Kurve 70 berücksichtigt, daß unterhalb eines Schwellenwerts von -3,7 die Abweichung des Istwerts des Gasflusses des Reaktivgases von dem Sollwert des Gasflusses des Reaktivgases als zu 100% "negativ" zu beurteilen ist, während oberhalb eines Schwellenwerts von +3,7 die Abweichung des Istwerts des Gasflusses des Reaktivgases von dem Sollwert des Gasflusses des Reaktivgases als zu 100% "positiv" zu beurteilen ist. Dementsprechend ist der Zugehörigkeitsgrad zur Fuzzymenge "Null" nur innerhalb des Bereichs von -3,7 bis +3,7 größer als 0%. Dadurch wird erreicht, daß einer starken Abweichung des Istwerts des Gasflusses des Reaktivgases von dessen Sollwert mit einer möglichst großen Korrektur begegnet wird.

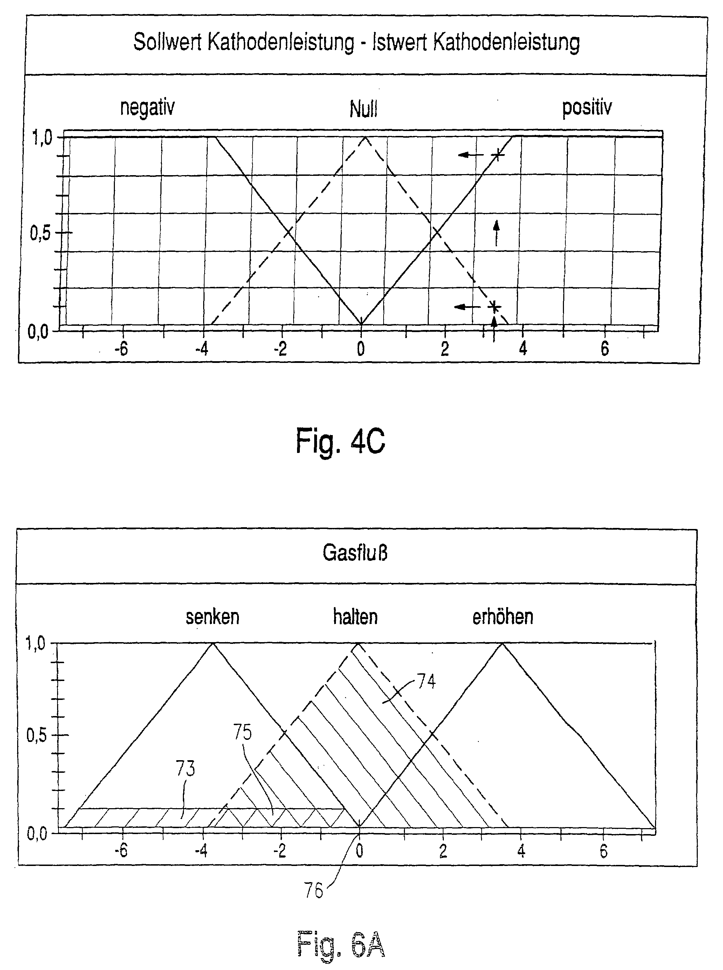

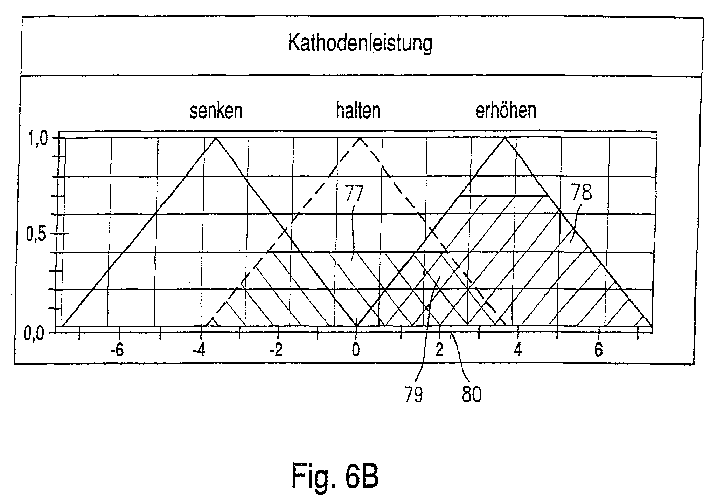

Die Kontrolleinheit 41 übermittelt ferner an die Fuzzyfizierungseinheit 42 die Meßgröße, die den Istwert der Kathodenleistung der Kathode 9 angibt. Die Verrechnungseinheit 65 bildet die Differenz zwischen dem Sollwert und dem Istwert der Kathodenleistung und setzt diesen in ein Signal um, das über die Signalleitung 66 an das Fuzzyfizierungsglied 58₃ weitergegeben wird. Das Fuzzyfizierungsglied 58₃ setzt dieses Signal durch Fuzzyfizierung zu einem fuzzyfizierten Signal um, das über die Signalleitung 49c von der Fuzzyfizierungseinheit 43 ausgegeben wird. Das über die Signalleitung 66 an das Fuzzyfizierungsglied 58₃ übergebene Signal wird, wie in Fig. 4C dargestellt, bezüglich linguistischen Variablen "negativ", "Null" und "positiv" fuzzyfiziert. Beispielsweise ist für ein Signal, bei dem der Sollwert der Kathodenleistung um 3,3 Einheiten über dem Istwert der Kathodenleistung liegt, der Zugehörigkeitsgrad für "negativ" 0%, der Zugehörigkeitsgrad für "Null" 10% und der Zugehörigkeitsgrad für "positiv" 90%.

Die von der Fuzzyfizierungseinheit 42 aus den Meßgrößen erhaltenen fuzzyfizierten Signale werden über die Signalleitung 49 an die Inferenzeinheit 43 weitergeleitet. Die in Fig. 2 dargestellte Inferenzeinheit 43 überlagert die fuzzyfizierten Signale, d.h. sie bringt diese zur Inferenz und ermittelt aufgrund vorgegebener Fuzzyregeln fuzzyfizierte Ergebnissignale für den Gasfluß des Reaktivgases und die Kathodenleistung der Kathode 9.

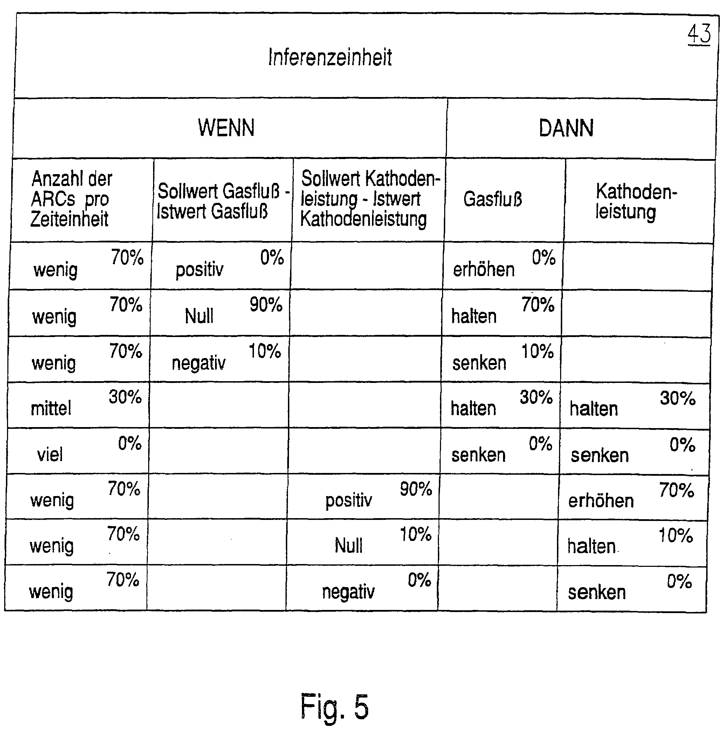

In Fig. 5 ist eine Tabelle dargestellt, die die Fuzzyregeln zur Überlagerung der fuzzyfizierten Signale umfaßt, um die fuzzyfizierten Ergebnissignale zu erhalten. Zur Auswertung der in der Tabelle angegebenen Fuzzyregeln ist ferner eine UND-Verknüpfung erforderlich, die die Zugehörigkeitsgrade zum Auswerten der Fuzzyregeln (WENN-DANN) verknüpft. Im beschriebenen Ausführungsbeispiel ist die UND-Verknüpfung durch die Minimumsfunktion gegeben.

Beispielsweise ergibt sich daraus, daß die Anzahl der ARCs pro Zeiteinheit zu 70% "wenig" ist und der Sollwert abzüglich des Istwerts des Gasflusses des Reaktivgases zu 90% "Null" ist, ein Zugehörigkeitsgrad von 70% für "halten" des Gasflusses des Reaktivgases. In Fig. 5 sind unter "WENN" die jeweiligen Zugehörigkeitsgrade zu den linguistischen Variablen, die aus den obigen anhand der Figuren 4A bis 4C beschriebenen Beispielswerten erhalten werden, eingetragen, woraus sich unter Berücksichtigung der Fuzzyregeln unter Zuhilfenahme der Minimumsfunktion als UND-Verknüpfung die unter "DANN" angegebenen Zugehörigkeitsgrade zu den linguistischen Variablen der fuzzyfizierten Ergebnissignalen ergeben.

Die fuzzyfizierten Ergebnissignale betreffen zum einen den Gasfluß des Reaktivgases und zum anderen die Kathodenleistung der Kathode 9. Das fuzzyfizierte Ergebnissignal des Gasflusses des Reaktivgases ist bezüglich der linguistischen Variablen "senken", "halten" und "erhöhen" fuzzyfiziert. Bezüglich entsprechenden linguistischen Variablen ist auch die Kathodenleistung der Kathode 9 fuzzyfiziert. Die ermittelten Zugehörigkeitsgrade zu den Fuzzymengen bzw. linguistischen Variablen werden von der Inferenzeinheit 43 mittels der Signalleitung 50 an die Defuzzyfizierungseinheit 44 weitergeleitet. In dem betrachteten Beispiel ergibt sich für den Gasfluß des Reaktivgases der Zugehörigkeitsgrad für "senken" zu 10%, der Zugehörigkeitsgrad für "halten" zu 100% und der Zugehörigkeitsgrad für "erhöhen" zu 0%. Für die Kathodenleistung ergibt sich der Zugehörigkeitsgrad für "senken" zu 0%, der Zugehörigkeitsgrad für "halten" zu 40% und der Zugehörigkeitsgrad für "erhöhen" zu 70%. Das die Summe der Zugehörigkeitsgrade für die Fuzzyfizierten Ergebnissignale jeweils mehr als 100% ergibt, ist für die nachfolgende Auswertung unerheblich, da die Defuzzyfizierungseinheit 44 implizit eine Normierung vornimmt.

Bei der Berechnung der fuzzyfizierten Ergebnissignale mittels der Fuzzy-Regeln (WENN-DANN) kann bei der Berechnung der Zugehörigkeitsgerade zu den linguistischen Variablen ein Gewichtungsfaktor berücksichtigt werden. Beispielsweise können für die linguistischen Variablen des Gasflusses, die in der Fig. 5 dargestellt sind, in der dargestellten Spalte zeilenweise folgende Gewichtungsfaktoren berücksichtigt werden: 0,20; 0,50; 0,20; 1,00 und 1,00. Bei der Verknüpfung von "wenig" (Zugehörigkeitsgrad 70%) und "NULL" (Zugehörigkeitsgrad 90%) zu "halten" ergibt sich dann anstelle von 70%, die ohne Gewichtungsfaktor erhalten werden, ein Zugehörigkeitsgrad von 35%.

Entsprechende Gewichtungsfaktoren können auch bei der Berechnung der Kathodenleistung mittels der in der Fig. 5 dargestellten Tabelle berücksichtigt werden. Besonders vorteilhafte Werte sind dabei für die Kathodenleistung: 1,00; 1,00; 0,20; 0,50 und 0,20. Somit ergibt sich aus "wenig" = 70% und "positiv" = 90% ein Zugehörigkeitsgrad für "erhöhen" von 14%.

Die Defuzzyfizierungseinheit 44 setzt die unscharfen Ergebnissignale in konkrete Ergebnissignale um, um Stellgrößen zu erhalten, die definierte Vorgaben für den Gasfluß des Reaktivgases und die Kathodenleistung der Kathode 9 darstellen.

Die Defuzzyfizierungseinheit 44 erhält folgende Eingangssignale:

| Gasfluß des Reaktivgases | |
|---|---|
| "senken" | 10% |
| "halten" | 100% |
| "erhöhen" | 0% |

| Kathodenleistung der Kathode 9 | |
|---|---|
| "senken" | 0% |
| "halten" | 40% |
| "erhöhen" | 70% |

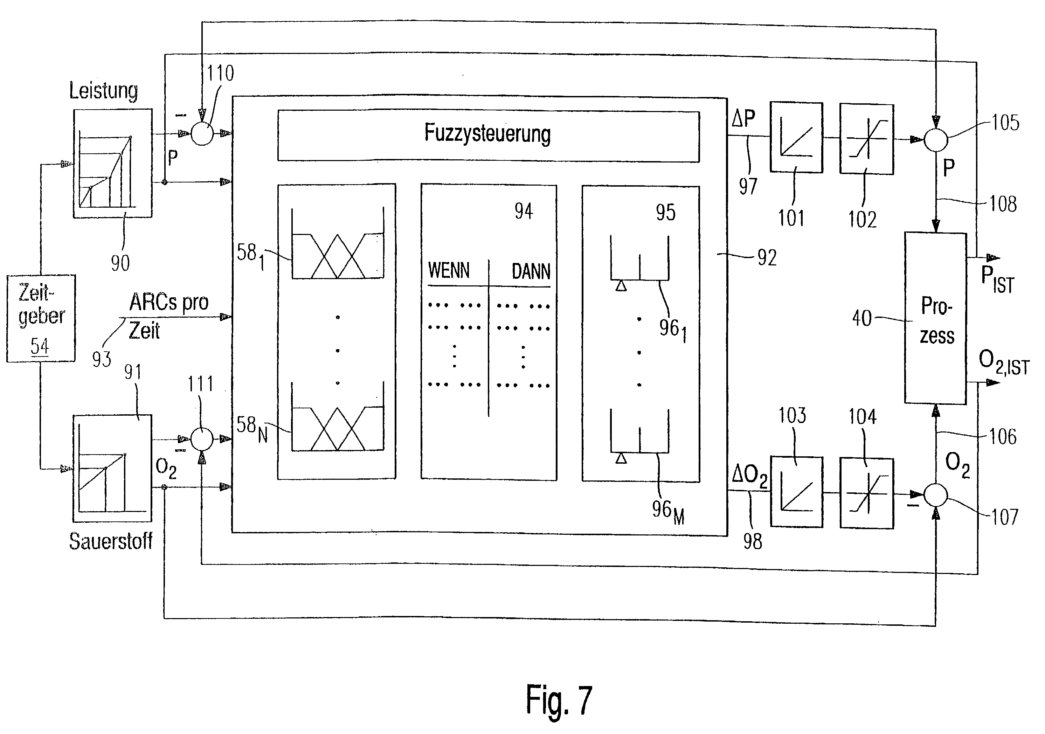

In Fig. 6A ist dargestellt, wie die Fuzzymengen für das fuzzyfizierte Ergebnissignal für den Gasfluß des Reaktivgases bezüglich der linguistischen Variablen "senken", "halten" und "erhöhen" überlagert werden, um das defuzzyfizierte Ergebnissignal für den Gasfluß zu erhalten. Die Fuzzymenge für "senken" wird bis zu einer Höhe, die 10% entspricht, gefüllt und die Fuzzymenge "halten" wird komplett gefüllt, was 100% entspricht. Dadurch ergeben sich die Flächen 73, 74. Die beiden Flächen 73, 74 überlagern sich in einem Überlagerungsbereich 75. Zur Defuzzyfizierung des fuzzyfizierten Ergebnissignals für den Gasfluß des Reaktivgases, d. h. der linguistischen Ausgangsvariablen für den Gasfluß des Reaktivgases, wird die x-Koordinate 76 des Schwerpunkts der beiden Flächen 73, 74 ermittelt, wobei der Überlagerungsbereich 75 nur einmal berücksichtigt wird. In dem beschriebenen Ausführungsbeispiel ergibt sich für die x-Koordinate 76 ein Wert von ungefähr -0,5, so daß der Gasfluß des Reaktivgases um 0,5 Einheiten zu senken ist. Da in dem beschriebenen Ausführungsbeispiel der Zugehörigkeitsgrad des ermittelten Ergebnissignals für den Gasfluß des Reaktivgases bezüglich der linguistischen Variablen "erhöhen" 0% ist, hat die in Fig. 6a dargestellte Fuzzymenge "erhöhen" in diesem Fall keinen Einfluß auf die Berechnung des Schwerpunkts.

Entsprechend wird auch das von der Inferenzeinheit 43 erzeugte bezüglich der linguistischen Variablen "senken", "halten" und "erhöhen" fuzzyfizierte Ergebnissignal der Kathodenleistung der Kathode 9 in der Defuzzyfizierungseinheit 44 zur Überlagerung gebracht, um ein defuzzyfiziertes Ergebnissignal für die Kathodenleistung in Form eines diskreten Ergebniswertes zu erhalten. In dem beschriebenem Beispiel hat das fuzzyfizierte Ergebnissignal bezüglich der linguistischen Menge "senken" einen Zugehörigkeitsgrad von 0%, so daß in diesem Fall die Fuzzymenge "senken" keinen Einfluß auf das Ergebnis hat. Die Fuzzymenge "halten" wird bis auf eine Höhe, die 40% entspricht, aufgefüllt, wodurch die Fläche 77 erhalten wird, und die Fuzzymenge "erhöhen" wird bis zu einer Höhe, die 70% entspricht, aufgefüllt, wodurch die Fläche 78 erhalten wird. Die Flächen 77, 78 überlagern sich in einem Überlagerungsbereich 79. Zur Defuzzyfizierung berechnet die Defuzzyfizierungseinheit 44 die x-Koordinate 80 des Schwerpunkts der Flächen 77, 78, wobei der Überlagerungsbereich 79 nur einmal herangezogen wird. In dem behandelten Zahlenbeispiel ergibt sich für die x-Koordinate 80 des Schwerpunkts ungefähr ein Wert von 2,2, was bedeutet, daß die Kathodenleistung um 2,2 Einheiten zu erhöhen ist.

Alternativ zur beschriebenen Berechnung der x-Koordinaten 76, 80 der erhaltenen Ergebnissignale mittels der Schwerpunktsmethode, kann auch die Singleton-Methode zum Einsatz kommen. Bei dieser wird jeder linguistischen variablen ein diskreter Wert in Form einer Peak-Funktion zugeordnet. Beispielsweise wird der linguistischen Variablen "senken" des Gasflusses ein Peak der Höhe 1 mit x-Koordinate -4, der linguistischen variablen "halten" ein Peak der Höhe 1 mit x-Koordinate 0 und der linguistischen Variblen "erhöhen" ein Peak der Höhe 1 mit x-Koordinate 4 zugeordnet. Das diskrete Ergebnissignal für den Gasfluß ergibt sich durch die Summe der mit den jeweiligen Zugehörigkeitsgraden multiplizierten Peak-Funktionen, wobei eine Normierung durch Teilen dieser.Summe durch die Summe der Zugehörigkeitsgrade vorgenommen wird.

Für das betrachtete Beispiel des Gasflusses, der anhand der Schwerpunktsmethode, wie in der Fig. 6A gezeigt, berechnet worden ist, ergibt sich mit der alternativen Berechnung nach der Singleton-Methode: 0,1 · (-4 + 1,1 · 0 + 0,0 · 4)/(0,1 + 1,0 + 0,0) = -0,36. Die Singleton-Methode hat den Vorteil, daß die Defuzzifizierung aufgrund der einfacheren Rechenopoerationen erheblich weniger Rechenzeit beansprucht.

Die ermittelten Werte werden an das in der Fig. 2 dargestellte Prozeßleitsystem 45 von der Defuzzyfizierungseinheit 44 über die Signalleitung 51 übermittelt. Das Prozeßleitsystem 45 überwacht, ob die Ergebnissignale in vorgegebenen Bereichen liegen. Falls eines oder beide der Ergebnissignale außerhalb des zugeordneten vorgegebenen Bereichs liegen, werden diese auf einen vorgegebenen Maximal- bzw. Minimalwert begrenzt. Bei einer Bereichsüberschreitung erzeugt das Prozeßleitsystem 45 außerdem ein Fehlersignal, das diese an die Kontrolleinheit 41 weiterleitet. Durch das Fehlersignal wird einem Operator, insbesondere einer Bedienperson, angezeigt, daß eine Bereichsüberschreitung vorliegt bzw. erfolgt ist.

Im normalen Betrieb, d.h. wenn das Prozeßleitsystem 45 kein Fehlersignal ausgegeben hat, überprüft die Kontrolleinheit 41 die durch die Einheiten 42 bis 45 bestimmten Stellgrößen und vergleicht diese mit den aus dem Prozeß 40 entnommenen Meßgrößen. Erst wenn die Meßgrößen in einem vorgegebenen Bereich um die ermittelten Stellgrößen liegen, gibt die Kontrolleinheit 41 die Verarbeitung der Meßgrößen zur Ermittlung neuer Stellgrößen durch die Einheiten 42 bis 45 frei. Dadurch wird gewährleistet, daß die Fuzzyregelung stets an den Prozeßparametern orientiert ist und den Prozeßparametern nicht davonläuft.

Die Kontrolleinheit 41 kann außerdem so eingestellt sein, daß diese, falls die Überwachungseinheit 45 ein Fehlersignal erzeugt bzw. erzeugt hat, solange die Freigabe zur Verarbeitung der Meßgrößen durch die Einheiten 42 bis 45 zur Erzeugung neuer Stellgrößen unterdrückt, bis ein Operator, insbesondere eine Bedienperson, die Ausgabe wieder freigibt. Die Kontrolleinheit 41 kann bei der Freigabe durch den Operator auch so eingestellt werden, daß sie das Freigabesignal nachfolgend sogar dann ausgibt, wenn eines oder beide Ergebnissignale weiterhin außerhalb des von dem Prozeßleitsystem 45 vorgegebenen Bereichs liegen.

Die Fig. 7 zeigt einen Signalflußplan gemäß einem weiteren Ausführungsbeispiel der Erfindung. Durch den gezeigten Signalflußplan wird das Verfahren zur Regelung der Sputterbeschichtungsanlage, die zur Beschichtung von zumindest einem Substrat dient, näher erläutert. Durch den Zeitgeber 54 wird eine Prozeßzeit bereitgestellt, aufgrund der die Kathode geregelt eingefahren wird, wodurch eine Einfahrregelung gegeben ist. Dabei stellt die Tabelle 90 für verschieden Zeitwerte bestimmte Leistungswerte zur Verfügung, zwischen denen eine lineare Interpolation erfolgt. Ferner ist auch für den Sauerstoff eine Tabelle 91 vorgesehen, die ebenfalls für verschiedene Zeitwerte diskrete Sollwerte für den Sauerstofffluß bereitstellt. Die erhaltenen Werte werden an die Fuzzysteuerung 92 übergeben. Die Fuzzysteuerung 92 weist N-Fuzzifizierungsglieder 58₁ - 58_{N} auf, die die erhaltenen Signale zu fuzzifizierten Eingangssignalen umsetzen. Dabei können neben der Leistung und dem Sauerstofffluß auch weitere Eingangssignale von der Fuzzysteuerung 92 mittels der Fuzzyfizierungsglieder 58₁ - 58_{N} verarbeitet werden, wobei in dem in der Fig. 7 dargestellten Ausführungsbeispiel als weitere Eingangsgröße das Signal 93, das die Anzahl der Einbrüche der Kathodenspannung pro Zeiteinheit angibt, verwendet wird.

Die von den Fuzzifizierungsgliedern 58₁ - 58_{N} fuzzifizierten Eingangssignale werden mittels den in der WENN-DANN-Tabelle 94 abgelegten Fuzzyregeln miteinander zu unscharfen, d. h. fuzzyfizierten Ergebnissignalen verrechnet, die in der Defuzzyfizierungseinheit 95 zu diskreten Ergebnissignalen umgesetzt werden. Dabei weist die Defuzzyfizierungseinheit 95 M Singleton-Defuzzyfizierungsglieder 96₁ - 96_{M} auf, so daß maximal M-Ergebnissignale ausgegeben werden können. In dem in der Fig. 7 dargestellten Ausführungsbeispiel werden zwei Ergebnissignale 97, 98, erhalten, wobei das Ergebnissignal 97 eine Druckänderung und das Ergebnissignal 98 eine Sauerstoffflußänderung angibt. Das Ergebnissignal 97 durchläuft anschließend das PID-Glied 101 und den Begrenzer 102 bevor es mit dem ursprünglichen Leistungssignal P im Knoten 105 zu dem auf den Prozeß 40 einwirkenden Stellsignal 108 verrechnet wird. Entsprechend durchläuft auch das Signal 98, das die Änderung des Gasflusses angibt, zunächst das PID-Glied 103 und den Begrenzer 104 bevor es subtraktiv mit dem ursprünglichen Signal für den Sauerstofffluß zu dem auf den Prozeß einwirkenden Stellsignal 106 im Knoten 107 verrechnet wird. Um den Regelkreis zu schließen, werden die aus dem Prozeß erhaltenen Meßgrößen P_{IST} und O_{2,IST} in den Knoten 110 und 111 mit den aus den Tabellen 90, 91 erhaltenen Signalen subtraktiv verrechnet, wobei die verrechneten Signale als Eingangssignale in die Fuzzysteuerung 92 einfließen.

Die Erfindung ist nicht auf das beschriebene Ausführungsbeispiel beschränkt. Insbesondere können in der Inferenzeinheit 43 andere Fuzzyregeln verwendet werden. Außerdem kann auch eine andere Anzahl an linguistischen Variablen für jedes der zu fuzzyfizierenden Signale vorgesehen werden. Ferner können die Fuzzymengen eine abweichende Gestalt aufweisen. Außerdem können auch weitere Prozeßparameter gemessen und von der Steuerschaltung mittels der Fuzzylogik verarbeitet werden.

## Patentansprüche

1. Sputterbeschichtungsanlage (1) zur Beschichtung von zumindest einem Substrat (2,3), insbesondere einer Glasscheibe, mit
zumindest einer Kathode (9), die mit einem Sputtertarget (10) verbunden ist,
zumindest einer Anode (7) und
zumindest einem Gaseinlaß (15, 16), durch den ein Reaktivgas in den Raum (17) zwischen der Anode (7) und dem Substrat (2, 3) bzw. dessen Transporteinrichtung (4) geleitet wird,
wobei die Kathode (9) gegenüber der Anode (7) mit einer Kathodenspannung beaufschlagt ist, um zwischen der Kathode (9) und der Anode (7) ein Plasma auszubilden,
**gekennzeichnet durch**
eine Regelschaltung (20), die die Meßgrößen Gasfluß des Reaktivgases und Kathodenleistung und die Meßgröße, die die Einbrüche der Kathodenspannung angibt, die infolge Entladung der Kathode (9) über das Plasma auftreten, erfaßt und in Abhängigkeit von diesen Meßgrößen den Gasfluß des Reaktivgases und die Kathodenleistung basierend auf einer Fuzzy-Logik regelt.

2. Sputterbeschichtungsanlage nach Anspruch 1,
**dadurch gekennzeichnet,**
**daß** die Regelschaltung (20) eine Fuzzyfizierungseinheit (42) umfaßt, die die Meßgrößen in fuzzyfizierte Signale umsetzt.

3. Sputterbeschichtungsanlage nach Anspruch 2,
**dadurch gekennzeichnet,**
**daß** ein Gasfluß-Sollwertspeicher (59) vorgesehen ist, der einen Sollwert für den Gasfluß des Reaktivgases bereitstellt,
**daß** der Istwert des Gasflusses des Reaktivgases mit dem Sollwert des Gasflusses des Reaktivgases zu einem Signal verrechnet wird und
**daß** die Fuzzyfizierungseinheit (42) das durch die Verrechnung erhaltene Signal fuzzyfiziert.

4. Sputterbeschichtungsanlage nach Anspruch 2 oder 3,
**dadurch gekennzeichnet,**
**daß** ein Kathodenleistung-Sollwertspeicher (63) vorgesehen ist, der einen Sollwert für die Kathodenleistung bereitstellt,
**daß** der Istwert der Kathodenleistung mit dem Sollwert der Kathodenleistung zu einem Signal verrechnet wird, und
**daß** die Fuzzyfizierungseinheit (42) das durch die Verrechnung erhaltene Signal fuzzyfiziert.

5. Sputterbeschichtungsanlage nach Anspruch 3 und 4,
**dadurch gekennzeichnet,**
**daß** ein Zeitgeber (54) vorgesehen ist, der ein Taktsignal erzeugt,
**daß** die Meßgröße, die die Einbrüche der Kathodenspannung angibt, mit dem Taktsignal zu einem Signal (ARC) umgesetzt wird, das die Anzahl der Einbrüche der Kathodenspannung pro Zeiteinheit angibt, und
**daß** die Fuzzyfizierungseinheit das durch die Umsetzung erhaltene Signal fuzzyfiziert.

6. Sputterbeschichtungsanlage nach Anspruch 5,
**dadurch gekennzeichnet,**
**daß** in dem Gasfluß-Sollwertspeicher (59) eine Vielzahl von Sollwerten für den Gasfluß des Reaktivgases und in dem Kathodenleistung-Sollwertspeicher (63) eine Vielzahl von Sollwerten für die Kathodenleistung hinterlegt sind,
wobei bestimmten Einfahrzeiten jeweils genau ein Sollwert für den Gasfluß des Reaktivgases und genau ein Sollwert für die Kathodenleistung zugeordnet sind, und
**daß**, wenn das Taktsignal des Zeitgebers (54) eine der vorbestimmten Einfahrzeiten erreicht, die Sollwertspeicher (59, 63) die Sollwerte bereitstellen, die dieser Einfahrzeit zugeordnet sind.

7. Sputterbeschichtungsanlage nach Anspruch 6,
**dadurch gekennzeichnet,**
**daß** die Regelschaltung (20) eine Kontrolleinheit (41) aufweist,
**daß** der Gasfluß-Sollwertspeicher (59) den Sollwert für den Gasfluß des Reaktivgases und der Kathodenleistung-Sollwertspeicher (63) den Sollwert für die Kathodenleistung nur erneuern, wenn die Kontrolleinheit (41) ein Freigabesignal ausgibt, und
**daß** die Kontrolleinheit (41) das Freigabesignal ausgibt, wenn der gemessene Istwert des Gasflusses des Reaktivgases innerhalb eines vorgegebenen Bereichs um den Sollwert des Gasflusses des Reaktivgases liegt und der gemessene Istwert der Kathodenleistung innerhalb eines vorgegebenen Bereichs um dem Sollwert der Kathodenleistung liegt.

8. Sputterbeschichtungsanlage nach einem der Ansprüche 5 bis 7,
**dadurch gekennzeichnet,**
**daß** die Regelschaltung (20) eine Inferenzeinheit (43) umfaßt, die die fuzzyfizierten Signale aufgrund von Fuzzyregeln miteinander verknüpft, um fuzzyfizierte Ergebnissignale für den Gasfluß des Reaktivgases und die Kathodenleistung zu erhalten.

9. Sputterbeschichtungsanlage nach Anspruch 8,
**dadurch gekennzeichnet,**
**daß** die Regelschaltung (20) eine Defuzzyfizierungseinheit (44), die die fuzzyfizierten Ergebnissignale in diskrete Ergebnissignale defuzzyfiziert, und ein Prozeßleitsystem (45) umfaßt, das überwacht, ob die Ergebnissignale in vorgegebenen Bereichen liegen und, falls zumindest ein Ergebnissignal außerhalb des zugeordneten vorgegebenen Bereichs liegt, dieses auf einen vorgegebenen Maximalbeziehungsweise Minimalwert begrenzt,
wobei der Gasfluß des Reaktivgases und die an der Kathode (9) anliegende Kathodenspannung unter Berücksichtigung der Ergebnissignale neu eingestellt werden.

10. Sputterbeschichtungsanlage nach Anspruch 9,
**dadurch gekennzeichnet,**
**daß** das Prozeßleitsystem (45), falls zumindest eines der Ergebnissignale den vorgegebenen Bereich überschritten hat, ein Fehlersignal erzeugt, das eine Bereichsüberschreitung des Ergebnissignals anzeigt.

11. Sputterbeschichtungsanlage nach Anspruch 10,
**dadurch gekennzeichnet,**
**daß** die Kontrolleinheit (41), falls das Prozeßleitsystem (45) ein Fehlersignal erzeugt, solange kein Freigabesignal, das die Erneuerung des Gasfluß-Sollwertes und des Kathodenleistung-Sollwertes freigibt, ausgibt, bis durch einen Operator, insbesondere eine Bedienperson, die Ausgabe wieder freigegeben ist.

12. Sputterbeschichtungsanlage nach Anspruch 11,
**dadurch gekennzeichnet,**
**daß**, falls das Prozeßleitsystem (45) ein Fehlersignal erzeugt und durch den Operator die Ausgabe des Freigabesignals der Kontrolleinheit freigegeben ist, die Kontrolleinheit (41) das Freigabesignal sogar dann ausgibt, wenn eines oder mehrere der Ergebnissignale weiterhin außerhalb der vorgegebenen Bereiche liegen.

13. Sputterbeschichtungsanlage nach einem der Ansprüche 1 bis 12,
**dadurch gekennzeichnet,**
**daß** zwischen der Kathode (9) und der Anode (7) zumindest zum Teil ein Inertgas vorgesehen ist.

14. Verfahren zur Regelung einer Sputterbeschichtungsanlage (1), die zur Beschichtung von zumindest einem Substrat (2, 3), insbesondere einer Glasscheibe, dient und zumindest eine Kathode (9), die mit einem Sputtertarget (10) verbunden ist, zumindest eine Anode (7) und zumindest einen Gaseinlaß (15, 16) aufweist, durch den ein Reaktivgas in den Raum (17) zwischen der Anode (7) und dem Substrat (2, 3) bzw. dessen Transporteinrichtung (4) geleitet wird, wobei die Kathode (9) gegenüber der Anode (7) mit einer Kathodenspannung beaufschlagt wird, um zwischen der Kathode (9) und der Anode (7) ein Plasma auszubilden,
**gekennzeichnet durch** folgende Verfahrensschritte:
a) Messen des Gasflusses des Reaktivgases;
b) Messen der Kathodenleistung der Kathode (9);
c) Messen der Anzahl der Einbrüche der Kathodenspannung, die infolge Entladung der Kathode (9) über das Plasma auftreten; und
d) Verarbeiten der Meßgrößen Gasfluß des Reaktivgases, Kathodenleistung und Anzahl der Einbrüche der Kathodenspannung unter Anwendung von vorbestimmten Fuzzyregeln zur Regelung des Gasflusses des Reaktivgases und der Kathodenleistung der Kathode (9).

15. Verfahren nach Anspruch 14,
**dadurch gekennzeichnet,**
**daß** im Verfahrensschritt (d) die Anzahl der Einbrüche der Kathodenspannung unter Verwendung eines Taktsignals in ein Signal (ARC) umgesetzt wird, das die Anzahl der Einbrüche der Kathodenspannung pro Zeiteinheit angibt, und
**daß** dieses Signal bezüglich der linguistischen Variablen "wenig", "mittel" und "viel" zu einem fuzzyfizierten Signal fuzzyfiziert wird;
**daß** der Istwert des Gasflusses des Reaktivgases von einem Sollwert des Gasflusses des Reaktivgases abgezogen wird und
das Ergebnis bezüglich der linguistischen Variablen "negativ", "Null" und "positiv" zu einem fuzzyfizierten Signal fuzzyfiziert wird;
**daß** der Istwert der Kathodenleistung von einem Sollwert der Kathodenleistung abgezogen wird und das Ergebnis bezüglich der linguistischen Variablen "negativ", "Null" und "positiv" zu einem fuzzyfizierten Signal fuzzyfiziert wird;
**daß** die fuzzyfizierten Signale gemäß vorgegebenen Fuzzyregeln miteinander verknüpft werden, wodurch ein bezüglich der linguistischen Variablen "senken", "halten" und "erhöhen" fuzzyfiziertes Ergebnissignal für den Gasfluß des Reaktivgases und ein bezüglich der linguistischen Variablen "senken", "halten" und "erhöhen" fuzzyfiziertes Ergebnissignal für die Kathodenleistung erhalten werden; und
**daß** die fuzzyfizierten Ergebnissignale auf diskrete Ergebnissignale defuzzyfiziert werden.

16. Verfahren nach Anspruch 15,
**dadurch gekennzeichnet,**
**daß** die Fuzzyregeln folgende Regeln umfassen:
"wenig" UND "positiv" ist gleich "erhöhen";
"wenig" UND "Null" ist gleich "halten";
"wenig" UND "negativ" ist gleich "senken";
"mittel" ist gleich "halten"; und
"viel" ist gleich "senken".

17. Verfahren nach Anspruch 16,
**dadurch gekennzeichnet,**
**daß** die in den Fuzzyregeln angegebene UND-Verknüpfung die Zugehörigkeitsgrade zu den linguistischen Variablen "wenig", "negativ", "Null" und "positiv" mittels der Minimumsfunktion verknüpft.

18. Verfahren nach einem der Ansprüche 14 bis 17,
**dadurch gekennzeichnen**,
daß zwischen der Kathode (9) und der Anode (7) zumindest zum Teil ein Inertgas vorgesehen ist.

## Claims

1. Sputter coating apparatus (1) for coating at least one substrate (2, 3), in particular a glass sheet, with
at least one cathode (9), which is connected to a sputtering target (10),
at least one anode (7) and
at least one gas inlet (15, 16), through which a reactive gas flows into the space (17) between the anode (7) and the substrate (2, 3) or its transport device (4),
whereby the cathode (9) opposite the anode (7) is subjected to a cathode voltage, to form a plasma between the cathode (9) and the anode (7),
**characterized by**
a regulating circuit (20), which acquires the parameters for the flow of reactive gas and cathode performance and the parameter, which indicates the amount of penetration of the cathode voltage, due to the cathode (9) discharging through the plasma, and as a function of these parameters regulates the flow of reactive gas and cathode performance based on fuzzy logic.

2. Sputter coating apparatus according to Claim 1,
**characterized in that**
the regulating circuit (20) comprises a fuzzification unit (42), which converts the parameters into fuzzy signals.

3. Sputter coating apparatus according to Claim 2,
**characterized in that**
a gas flow desired value memory (59) is provided, which supplies a desired value for the flow of reactive gas,
that the actual value for the flow of reactive gas is offset against the desired value for the flow of reactive gas to generate a signal and
that the fuzzification unit (42) fuzzifies the signal generated in this way.

4. Sputter coating apparatus according to Claim 2 or 3,
**characterized in that**
a cathode performance desired value memory (63) is provided, which supplies a desired value for the cathode performance,
that the actual value for the cathode performance is offset against the desired value for the cathode performance to generate a signal, and
that the fuzzification unit (42) fuzzifies the signal generated in this way.

5. Sputter coating apparatus according to Claim 3 and 4,
**characterized in that**
a timer (54) is provided, which generates a clock pulse, that the parameter, which indicates the amount of penetration of the cathode voltage, is converted with the clock pulse to generate a signal (ARC), which indicates the amount of penetration of the cathode voltage per unit of time, and
that the fuzzification unit fuzzifies the signal generated in this way.

6. Sputter coating apparatus according to Claim 5,
**characterized in that**
a plurality of desired values for the flow of reactive gas is stored in the gas flow desired value memory (59),
and a plurality of desired values for the cathode performance is stored in the cathode performance desired value memory (63),
whereby in each case just one desired value for the flow of reactive gas and just one desired value for the cathode performance are associated with specific plant power-up times and
that, if the clock pulse of the timer (54) reaches one of the pre-set plant power-up times, the desired value memories (59, 63) provide the desired values, which are associated with this plant power-up time.

7. Sputter coating apparatus according to Claim 6,
**characterized in that**
the regulating circuit (20) has a monitoring unit (41), that the gas flow desired value memory (59) and the cathode performance desired value memory (63) only renew the desired value for the cathode performance and the desired value for the flow of reactive gas, when the monitoring unit (41) emits an enabling signal, and
that the monitoring unit (41) emits the enabling signal, if the measured actual value for the flow of reactive gas within a pre-set range lies around the desired value for the flow of reactive gas and the measured actual value for the cathode performance within a pre-set range lies around the desired value for the cathode performance.

8. Sputter coating apparatus according to any one of Claims 5 to 7,
**characterized in that**
the regulating circuit (20) comprises an inference unit (43), which links the fuzzy signals with one another on the basis of fuzzy rules, in order to generate fuzzy output signals for the flow of reactive gas and the cathode performance.

9. Sputter coating apparatus according to Claim 8,
**characterized in that** the regulating circuit (20) comprises a defuzzification unit (44), which defuzzifies the fuzzy output signals into discrete output signals, and a process control system (45), which monitors whether the output signals lie within pre-set ranges, and if at least one output signal lies outside the associated pre-set range, whether this is limited to a pre-determined maximum or minimum value,
whereby the flow of reactive gas and the cathode voltage lying on the cathode (9) are re-adjusted under consideration of the output signals.

10. Sputter coating apparatus according to Claim 9,
**characterized in that**
the process control system (45) generates an error signal to indicate the output signal is outside range, if at least one of the output signals has exceeded the pre-set range.

11. Sputter coating apparatus according to Claim 10,
**characterized in that**
the monitoring unit (41), if the process control system (45) generates an error signal, will not emit an enabling signal, which triggers renewal of the gas flow desired value and the cathode performance desired value, until the enabling signal is again released by an operator, in particular a control person.

12. Sputter coating apparatus according to Claim 11,
**characterized in that**,
if the process control system (45) generates an error signal and the enabling signal of the monitoring unit is released by the operator, the monitoring unit (41) emits the enabling signal even when one or several of the output signals continue to lie outside the pre-set ranges.

13. Sputter coating apparatus according to any one of Claims 1 to 12,
**characterized in that**
an inert gas is provided at least partially between the cathode (9) and the anode (7).

14. Process for regulating a sputter coating apparatus (1), which serves to coat at least one substrate (2, 3), in particular a glass sheet, and has at least one cathode (9), which is connected to a sputtering target (10), at least one anode (7) and at least one gas inlet (15, 16), through which reactive gas is fed into the space (17) between the anode (7) and the substrate (2, 3) or its transport device (4), whereby the cathode (9) opposite the anode (7) is subjected to a cathode voltage, in order to form a plasma between the cathode (9) and the anode (7), **characterized by** the following process steps:
a) measurement of the flow of reactive gas;
b) measurement of the performance of the cathode (9);
c) measurement of the amount of penetration of the cathode voltage, which arises due to the cathode (9) discharging through the plasma; and
d) processing of the parameters: flow of reactive gas, cathode performance and amount of penetration of the cathode voltage with pre-determined fuzzy rules being applied for regulating the flow of reactive gas and the performance of the cathode (9).

15. Process according to Claim 14,
**characterized in that**
in process step (d) the amount of penetration of the cathode voltage is converted using a clock pulse into a signal (ARC), which indicates the amount of penetration of the cathode voltage per unit of time, and
that this signal is fuzzified with regard to the linguistic variables "little", "medium" and "much" into a fuzzy signal;
that the actual value for the flow of reactive gas is deducted from a desired value for the flow of reactive gas and the result with regard to the linguistic variables "negative", "zero" and "positive" is fuzzified into a fuzzy signal;
that the actual value for the cathode performance is deducted from a desired value for the cathode performance and the result is fuzzified with regard to the linguistic variables "negative", "zero" and "positive" into a fuzzy signal;
that the fuzzy signals are linked with one another in accordance with pre-determined fuzzy rules, whereby an output signal for the flow of reactive gas fuzzified with regard to the linguistic variables "lower", "hold" and "increase" and a output signal for the cathode performance fuzzified with regard to the linguistic variables "lower", "hold" and "increase" are generated; and
that the fuzzy output signals are defuzzified into discrete output signals.

16. Process according to Claim 15,
**characterized in that**
the fuzzy rules comprise the following conditions:
"little" AND "positive" is equal to "increase";
"little" AND "zero" is equal to "hold";
"little" AND "negative" is equal to "lower";
"medium" is equal to "hold"; and
"much" is equal to "lower".

17. Process according to Claim 16,
**characterized in that**
the AND link indicated in the fuzzy rules links the degree of association with the linguistic variables "little", "negative", "zero" and "positive" by means of the minimum function.

18. Process according to any one of Claims 14 to 17,
**characterized in that**
an inert gas is provided at least partially between the cathode (9) and the anode (7).

## Revendications

1. Appareil de pulvérisation cathodique (1) pour le revêtement d'au moins un substrat (2,3), en particulier une plaque de verre, comportant au moins une cathode (9) reliée à une cible de pulvérisation (10), au moins une anode (7) et au moins une admission de gaz (15, 16) à travers laquelle un gaz réactif est amené dans l'espace (17) situé entre l'anode (7) et le substrat (2, 3) et/ou son installation de transport (4), la cathode (9) à l'opposé de l'anode (7) étant alimentée par une tension de cathode pour former un plasma entre la cathode (9) et l'anode (7), **caractérisé par** un circuit de réglage (20) qui détecte les grandeurs de mesure du flux de gaz du gaz réactif et de la capacité de cathode ainsi que la grandeur de mesure indiquant les effondrements de la tension de cathode se produisant à travers le plasma, en conséquence de la décharge de la cathode (9) et en fonction de ces grandeurs de mesure, règle, sur la base d'une logique floue, le flux de gaz du gaz réactif et la capacité de cathode.

2. Appareil de pulvérisation cathodique selon la revendication 1, **caractérisé en ce que** le circuit de réglage (20) comprend une unité de flouification (42) qui convertit les grandeurs de mesure en signaux flouifiés.

3. Appareil de pulvérisation cathodique selon la revendication 2, **caractérisé en ce qu'**est prévue une mémoire des valeurs prescrites du flux de gaz (59) qui fournit une valeur prescrite pour le flux de gaz du gaz réactif, **en ce que** la valeur effective du flux de gaz du gaz réactif est compensée en un signal avec la valeur prescrite du flux de gaz du gaz réactif et **en ce que** l'unité de flouification (42) flouifie le signal obtenu par la compensation.

4. Appareil de pulvérisation cathodique selon la revendication 2 ou 3, **caractérisé en ce qu'**est prévue une mémoire des valeurs prescrites de la capacité de cathode (63) qui fournit une valeur prescrite pour la capacité de cathode, **en ce que** la valeur effective de la capacité de cathode est compensée en un signal avec la valeur prescrite de la capacité de cathode, et **en ce que** l'unité de flouification (42) flouifie le signal obtenu par la compensation.

5. Appareil de pulvérisation cathodique selon les revendications 3 et 4, **caractérisé en ce qu'**est prévu un registre d'horloge (54) qui produit un signal d'horloge, **en ce que** la grandeur de mesure qui indique les effondrements de la tension de cathode est convertie en un signal (ARC) avec le signal d'horloge, qui indique le nombre d'effondrements de la tension de cathode par unité de temps, et **en ce que** l'unité de flouification flouifie le signal obtenu par la conversion.

6. Appareil de pulvérisation cathodique selon la revendication 5, **caractérisé en ce qu'**une multiplicité de valeurs prescrites pour le flux de gaz du gaz réactif est enregistrée dans la mémoire des valeurs prescrites du flux de gaz (59), et, une multiplicité de valeurs prescrites pour la capacité de cathode, est enregistrée dans la mémoire des valeurs prescrites de la capacité de cathode (63), tandis que sont chaque fois affectées à des temps de positionnement déterminés, exactement une valeur prescrite pour le flux de gaz du gaz réactif et exactement une valeur prescrite pour la capacité de cathode, et **en ce que**, lorsque le signal d'horloge du registre d'horloge (54) atteint l'un des temps de positionnement préétablis, les mémoires des valeurs prescrites (59, 63) fournissent les valeurs prescrites qui sont affectées à ce temps de positionnement.

7. Appareil de pulvérisation cathodique selon la revendication 6, **caractérisé en ce que** le circuit de réglage (20) présente une unité de contrôle (41), **en ce que** la mémoire des valeurs prescrites du flux de gaz (59) et la mémoire des valeurs prescrites de la capacité de cathode (63) ne font que renouveler la valeur prescrite pour le flux de gaz du gaz réactif et la valeur prescrite de la capacité de cathode lorsque l'unité de contrôle (41) délivre un signal d'autorisation, et **en ce que** l'unité de contrôle (41) délivre le signal d'autorisation, lorsque la valeur effective mesurée du flux de gaz du gaz réactif se trouve à l'intérieur d'un niveau préétabli autour de la valeur prescrite du flux de gaz du gaz réactif et que la valeur effective mesurée de la capacité de cathode se trouve à l'intérieur d'un niveau préétabli autour de la valeur prescrite de la capacité de cathode.

8. Appareil de pulvérisation cathodique selon l'une des revendications 5 à 7, **caractérisé en ce que** le circuit de réglage (20) comprend une unité d'inférence (43) qui sur la base de règles de flouification combine les signaux flouifiés afin d'obtenir des signaux de résultat pour le flux de gaz du gaz réactif et la capacité de cathode.

9. Appareil de pulvérisation cathodique selon la revendication 8, **caractérisé en ce que** le circuit de réglage (20) comprend une unité de déflouification (44) qui déflouifie en signaux discrets de résultat les signaux de résultat flouifiés, et un système d'autoguidage du procédé (45) qui surveille si les signaux de résultat se trouvent aux niveaux préétablis et, au cas où au moins un signal de résultat se trouve en dehors du niveau préétabli affecté, limite celui-ci à une valeur prescrite maximale et/ou minimale, sachant que le flux de gaz du gaz réactif et la tension de cathode se produisant sur la cathode (9) sont réajustés compte tenu des signaux de résultat.

10. Appareil de pulvérisation cathodique selon la revendication 9, **caractérisé en ce que** le système d'autoguidage du procédé (45), au cas où au moins un des signaux de résultat a dépassé le niveau préétabli, produit un signal d'erreur qui indique un dépassement du niveau des signaux de résultat.

11. Appareil de pulvérisation cathodique selon la revendication 10, **caractérisé en ce que** l'unité de contrôle (41), au cas où le système d'autoguidage du procédé (45) produit un signal d'erreur, ne délivre aucun signal d'autorisation qui autorise le renouvellement de la valeur prescrite du flux de gaz et de la valeur prescrite de la capacité de cathode, tant que la délivrance n'a pas été autorisée à nouveau par un opérateur, en particulier une personne de service.

12. Appareil de pulvérisation cathodique selon la revendication 11, **caractérisé en ce que**, si le système d'autoguidage du procédé (45) produit un signal d'erreur et que la délivrance du signal d'autorisation de l'unité de contrôle est autorisée par l'opérateur, l'unité de contrôle (41) délivre le signal d'autorisation, même lorsqu'un ou plusieurs des signaux de résultat continuent à se trouver en dehors des niveaux préétablis.

13. Appareil de pulvérisation cathodique selon l'une des revendications 1 à 12, **caractérisé en ce qu'**un gaz inerte est au moins partiellement prévu entre la cathode (9) et l'anode (7).

14. Procédé pour le réglage d'un appareil de pulvérisation cathodique (1) qui sert au revêtement d'au moins un substrat (2, 3), en particulier une plaque de verre, et présente au moins une cathode (9) reliée à une cible de pulvérisation (10), au moins une anode (7), et au moins une admission de gaz (15, 16) à travers laquelle est conduit un gaz réactif dans l'espace (17) situé entre l'anode (7) et le substrat (2, 3) et/ou son installation de transport (4), tandis que la cathode (9), à l'opposé de l'anode (7), est alimentée par une tension de cathode pour former un plasma entre la cathode (9) et l'anode (7), **caractérisé par** les étapes suivantes du procédé :
a) mesure du flux de gaz du gaz réactif ;
b) mesure de la capacité de cathode de la cathode (9) ;
c) mesure du nombre des effondrements de la tension de cathode qui se produisent à la suite de la décharge de la cathode (9) à travers le plasma ; et
d) traitement des grandeurs de mesure du flux de gaz du gaz réactif, de la capacité de cathode et des effondrements de la tension de cathode, en utilisant des règles préétablies de flouification pour régler le flux de gaz du gaz réactif et la capacité de cathode de la cathode (9).

15. Procédé selon la revendication 14, **caractérisé en ce qu'**à l'étape (d) du procédé, le nombre des effondrements de la tension de cathode, en utilisant un signal d'horloge, est converti en un signal (ARC) qui indique le nombre d'effondrements de la tension de cathode par unité de temps, et **en ce que** ce signal, relativement aux variables linguistiques "moins", "moyen" et "beaucoup", est flouifié en un signal flouifié ; **en ce que** la valeur effective du flux de gaz du gaz réactif est ôtée d'une valeur prescrite du flux de gaz du gaz réactif, et le résultat relativement aux variables linguistiques "négatif", "nul" et "positif", est flouifié en un signal flouifié ; **en ce que** la valeur effective de la capacité de cathode est ôtée d'une valeur prescrite de la capacité de cathode, et le résultat relativement aux variables linguistiques "négatif", "nul" et "positif", est flouifié en un signal flouifié ; **en ce que** les signaux flouifiés sont combinés ensemble selon des règles préétablies de flouification, ce par quoi sont obtenus, un signal de résultat flouifié relativement aux variables linguistiques "abaisser", "maintenir" et "augmenter" pour le flux de gaz du gaz réactif, et un signal de résultat flouifié relativement aux variables linguistiques "abaisser", "maintenir" et "augmenter" pour la capacité de cathode ; et **en ce que** les signaux de résultat flouifiés sont déflouifiés en discrets signaux de résultat.

16. Procédé selon la revendication 15, **caractérisé en ce que** les règles de flouification englobent les règles suivantes :
"moins" ET "positif" égale "augmenter" ;
"moins" ET "nul" égale "tenir" ;
"moins" ET "négatif" égale "abaisser" ;
"moyen" égale "maintenir" ; et
"beaucoup" égale "abaisser".

17. Procédé selon la revendication 16, **caractérisé en ce que** la fonction logique ET indiquée dans les règles de flouification, se combine, au moyen de la fonction minimum, aux variables linguistiques "moins", "négatif", "nul" et "positif".

18. Procédé selon l'une des revendications 14 à 17, **caractérisé en ce qu'**un gaz inerte est au moins partiellement prévu entre la cathode (9) et l'anode (7).
